# EUROPEAN PATENT APPLICATION

(11) **EP 4 312 254 A1**
(43) Date of publication of application: **31.01.2024**
(21) Application number: 23177602.2
(22) Date of filing: 06.06.2023
(51) Int. Cl.: H01L 23/00, C25D 3/38

(54) **PACKAGE STRUCTURE AND MANUFACTURING METHOD THEREOF**

(30) Priority: 28.07.2022 CN 202221973861 U
(71) Applicant: Advanced Semiconductor Engineering, Inc., Kaohsiung 811 (TW)
(72) Inventor: LIN, Erh-Ju, 811 KAOHSIUNG (TW)
(74) Representative: Viering, Jentschura & Partner mbB Patent- und Rechtsanwälte

(57) **Abstract**

A package structure is provided. The package structure includes a substrate, a conductive pad, and a conductive wire. The conductive pad is disposed over the substrate. The conductive wire includes an end portion connected to the conductive pad, wherein a grain arrangement of the end portion is distinct from a grain arrangement of the conductive pad.

## Description

### BACKGROUND

### 1. Technical Field

The present disclosure relates generally to a package structure and a manufacturing method thereof. Specifically, the present disclosure relates to a package structure including a nanotwinned copper (NT-Cu) pad and a manufacturing method thereof.

### 2. Description of the Related Art

Currently, one or more aluminum pads on a chip may be bonded to a substrate by a wiring bonding process using conductive wires that are made of a material (e.g., gold or copper) different from that of the aluminum pads. As a result, electrolytic corrosion may occur to the aluminum pads in a relatively humid environment due to potential differences among the different materials of the aluminum pads and the conductive wires. In addition, intermetallic compounds (IMCs) can be formed between the different materials of the aluminum pads and the conductive wires, which may consume the material of the aluminum pads and result in embrittlement of the aluminum pads and subsequent reliability problems. Moreover, the formation of IMCs can generate voids in the aluminum pads, which can increase the resistance of the aluminum pads and adversely affect the conductivity of the package structure. Therefore, a technical solution is needed to solve the above technical problems.

### SUMMARY

In one or more arrangements, a package structure includes a substrate, a conductive pad, and a conductive wire. The conductive pad is disposed over the substrate. The conductive wire includes an end portion connected to the conductive pad, wherein a grain arrangement of the end portion is distinct from a grain arrangement of the conductive pad.

In one or more arrangements, a package structure includes a substrate, a conductive pad, a first oxide layer, and a conductive wire. The conductive pad is disposed over the substrate and has an anisotropic crystal structure. The first oxide layer is over the conductive pad. The conductive wire includes an end portion penetrating the first oxide layer and contacting the anisotropic crystal structure.

In one or more arrangements, a package structure includes a substrate, a first pad, a second pad, and a conductive wire. The first pad and the second pad are disposed over the substrate, wherein the first pad includes a first grain extending upwards from the substrate, and the second pad includes a second grain extending upwards from the substrate. The conductive wire includes a ball portion connected to the first pad and a stitch portion connected to the second pad. The first grain includes a first bending portion, the second crystal grain includes a second bending portion, and the first bending portion is more inclined than the second bending portion.

### BRIEF DESCRIPTION OF THE DRAWINGS

Aspects of the present disclosure are better understood from the following detailed description when read with the accompanying drawings. It is noted that various features may not be drawn to scale, and the dimensions of the various features may be arbitrarily increased or reduced for clarity of discussion.
FIG. 1 is a schematic view of a package structure in accordance with some arrangements of the present disclosure.
FIG. 1A is a cross-section of a portion of a package structure in accordance with some arrangements of the present disclosure.
FIG. 2A is a cross-section of a portion of a package structure in accordance with some arrangements of the present disclosure.

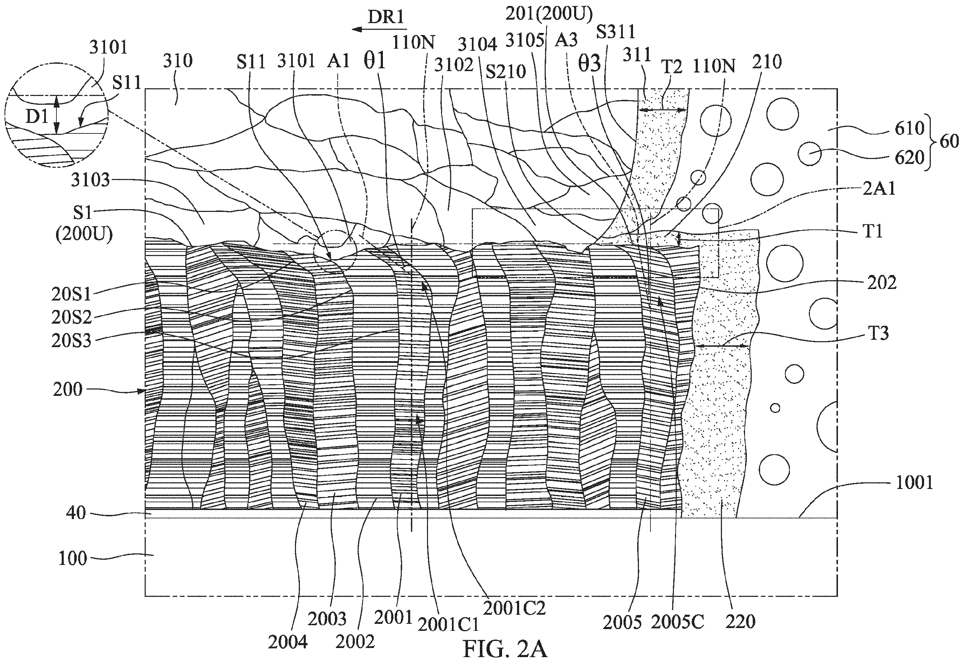

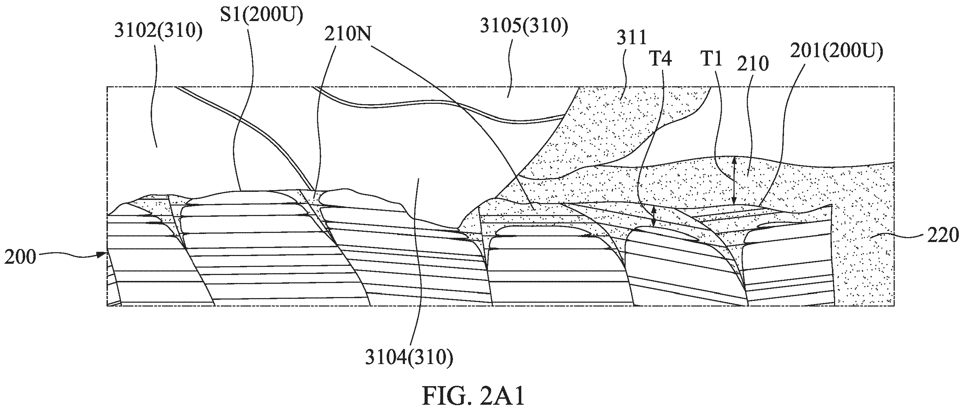

FIG. 2A1 is a cross-section of a portion of a package structure in accordance with some arrangements of the present disclosure.

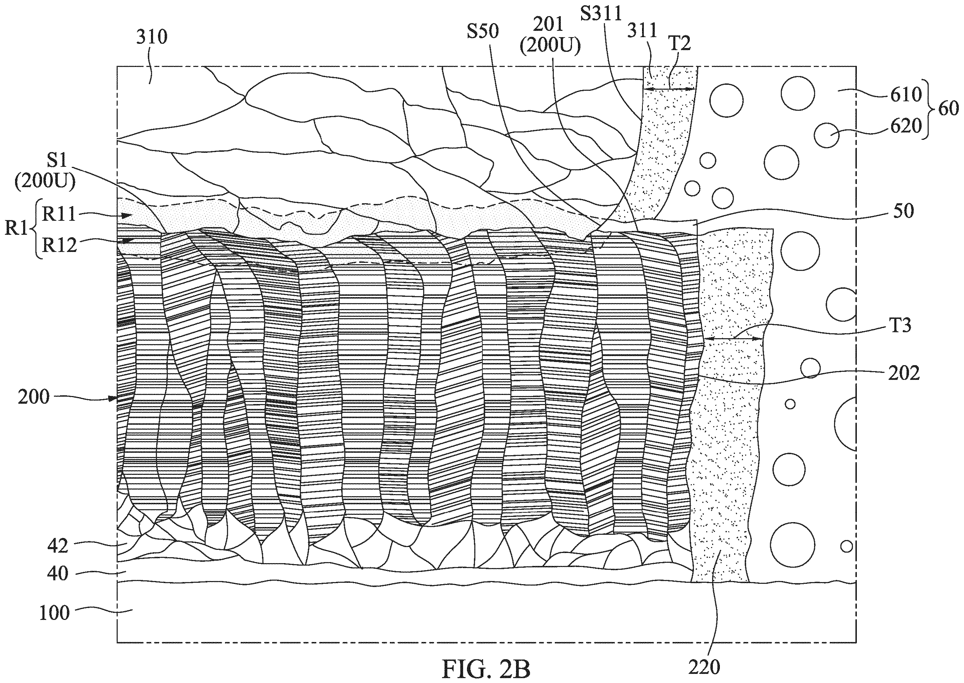

FIG. 2B is a cross-section of a portion of a package structure in accordance with some arrangements of the present disclosure.

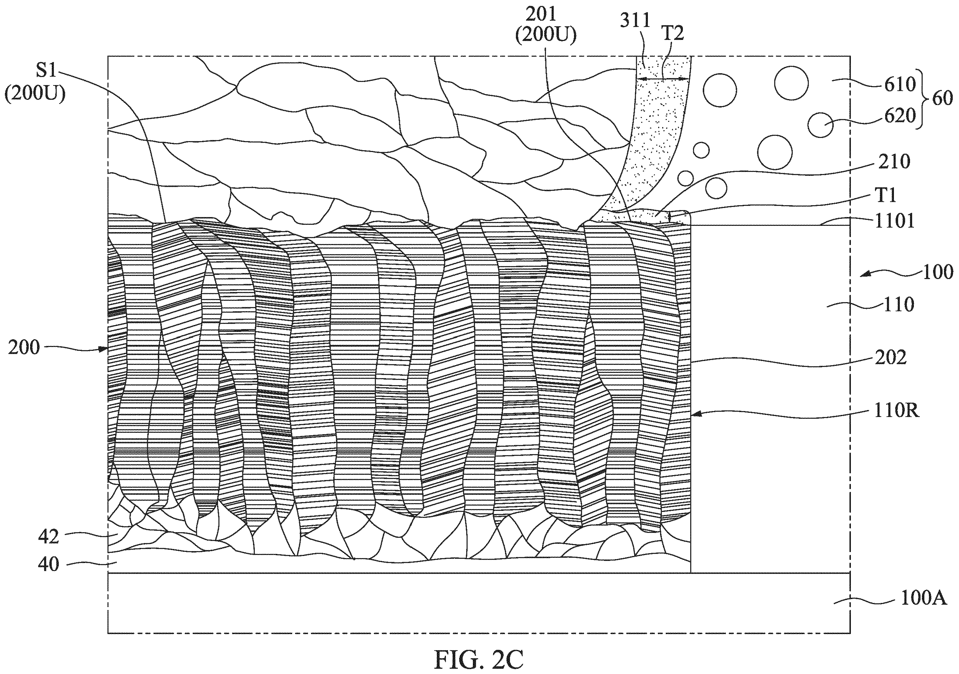

FIG. 2C is a cross-section of a portion of a package structure in accordance with some arrangements of the present disclosure.

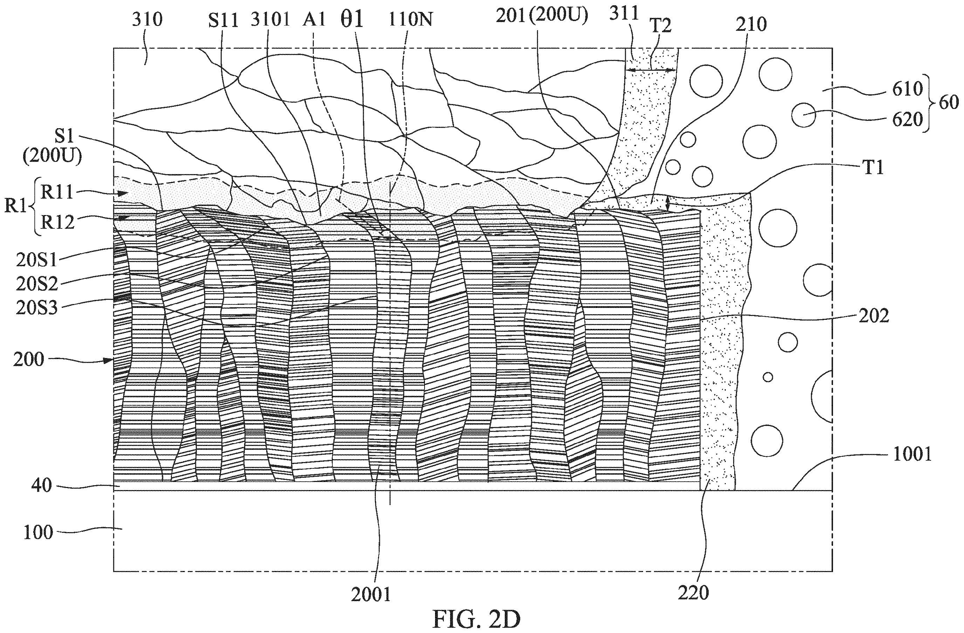

FIG. 2D is a cross-section of a portion of a package structure in accordance with some arrangements of the present disclosure.

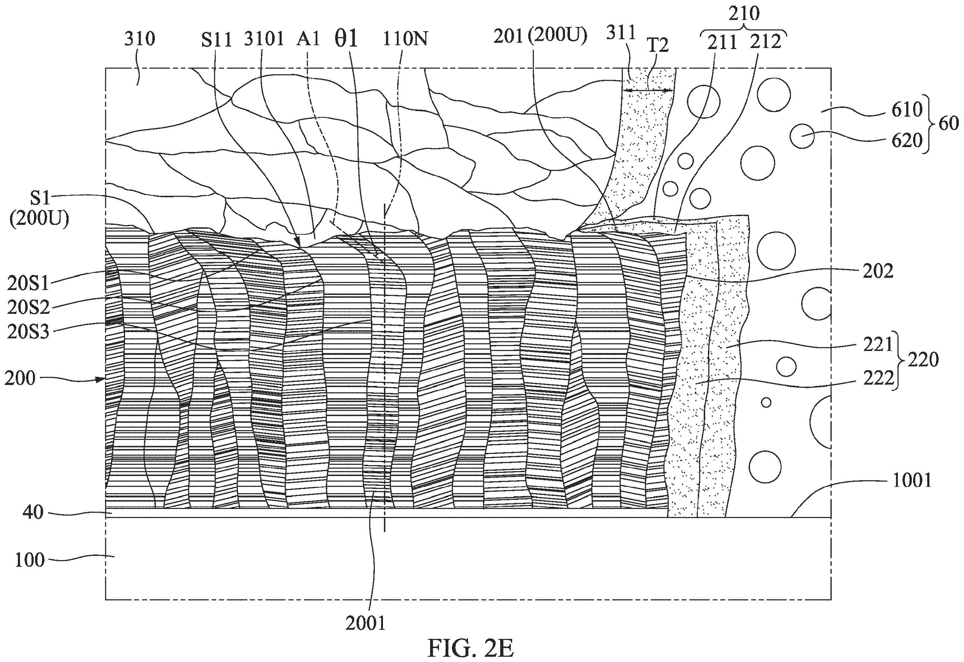

FIG. 2E is a cross-section of a portion of a package structure in accordance with some arrangements of the present disclosure.

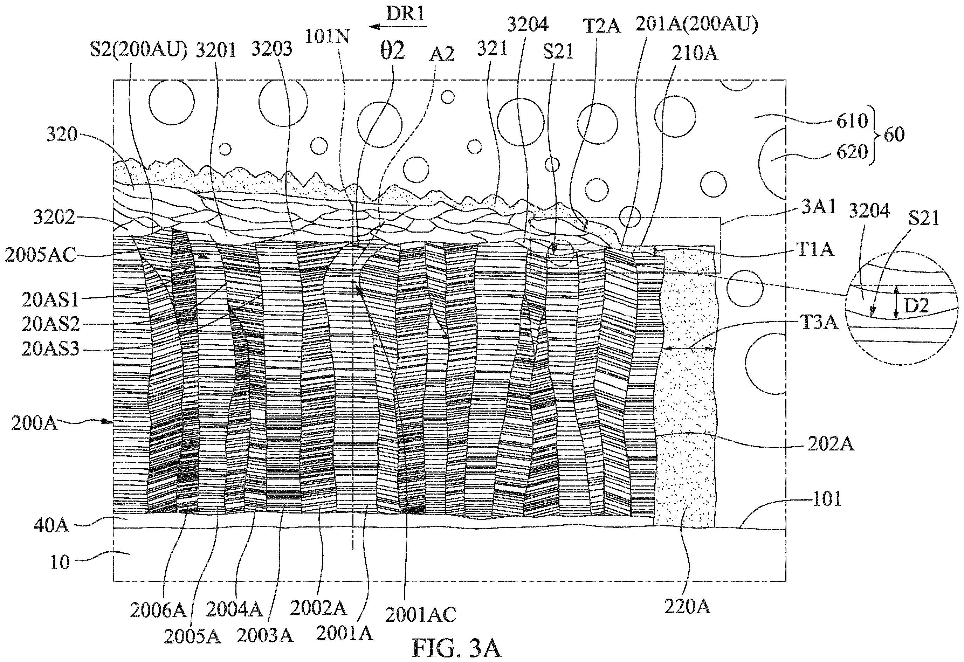

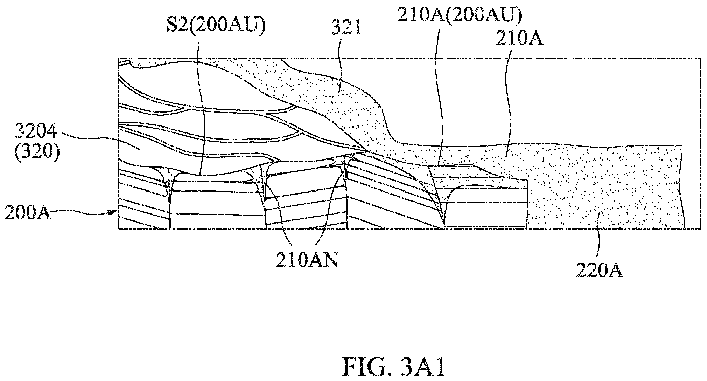

FIG. 3A is a cross-section of a portion of a package structure in accordance with some arrangements of the present disclosure.
FIG. 3A1 is a cross-section of a portion of a package structure in accordance with some arrangements of the present disclosure.

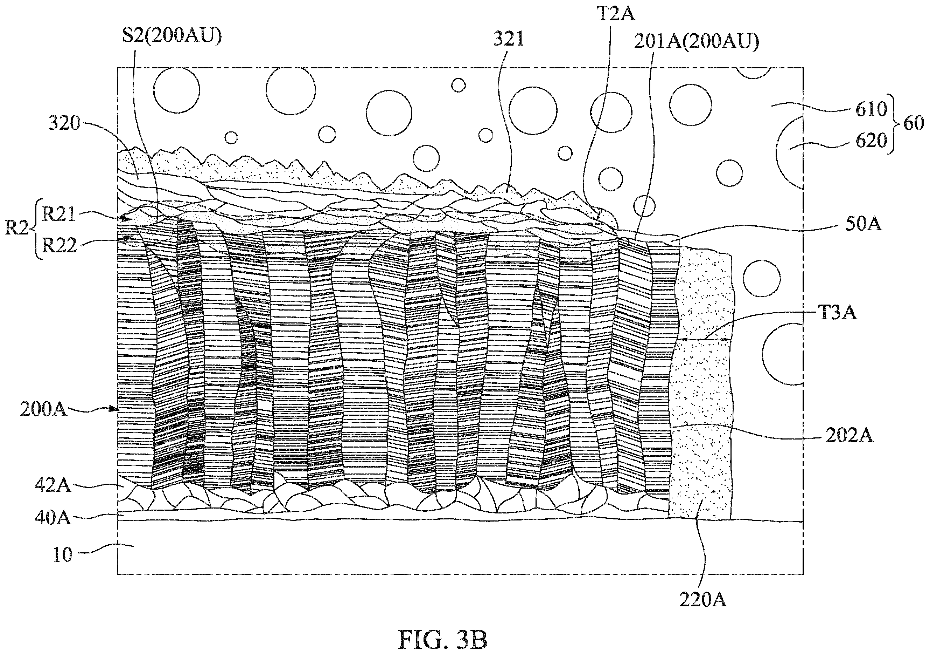

FIG. 3B is a cross-section of a portion of a package structure in accordance with some arrangements of the present disclosure.

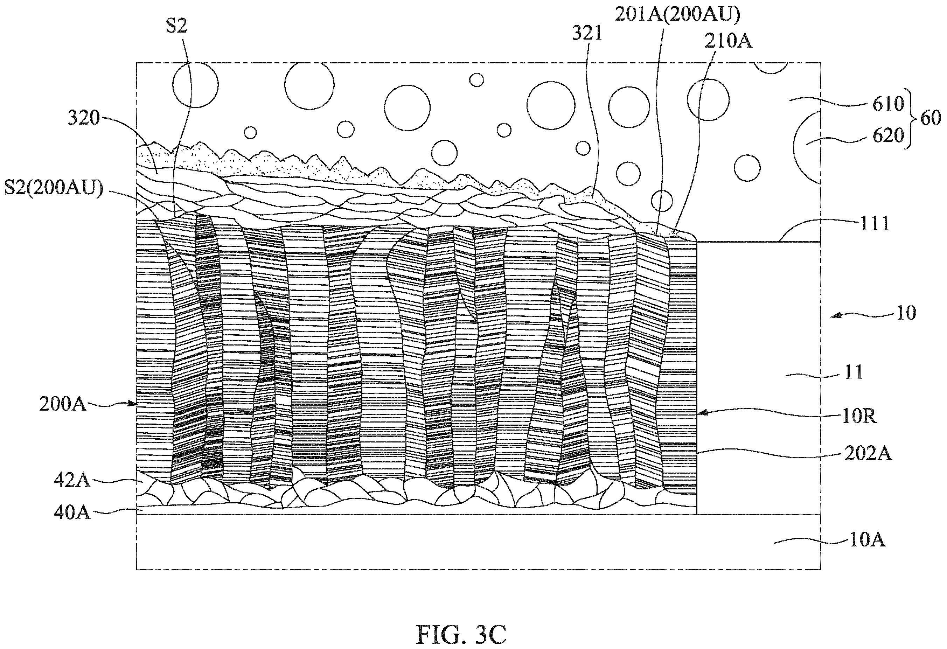

FIG. 3C is a cross-section of a portion of a package structure in accordance with some arrangements of the present disclosure.

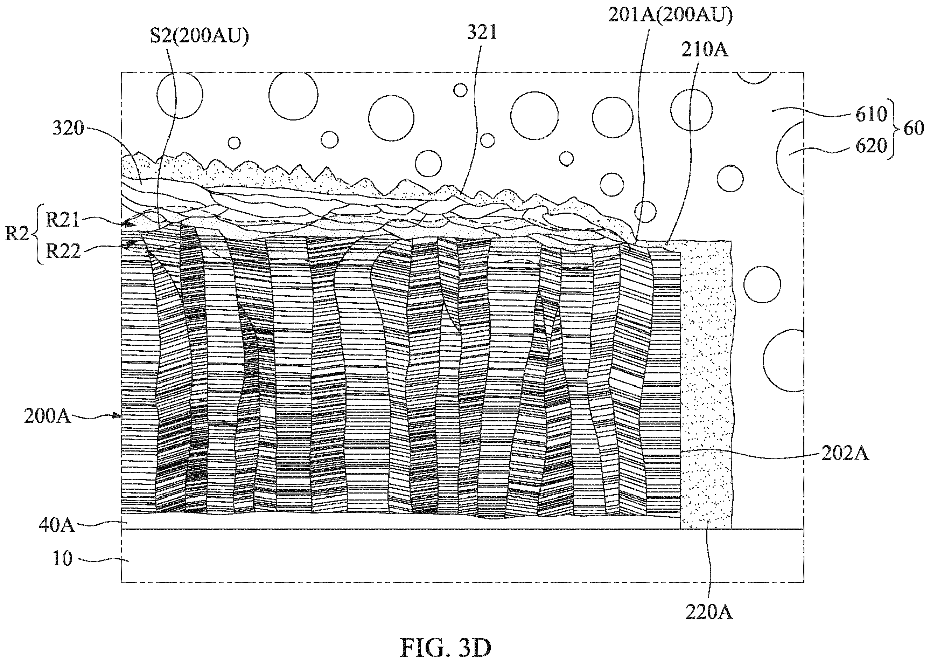

FIG. 3D is a cross-section of a portion of a package structure in accordance with some arrangements of the present disclosure.

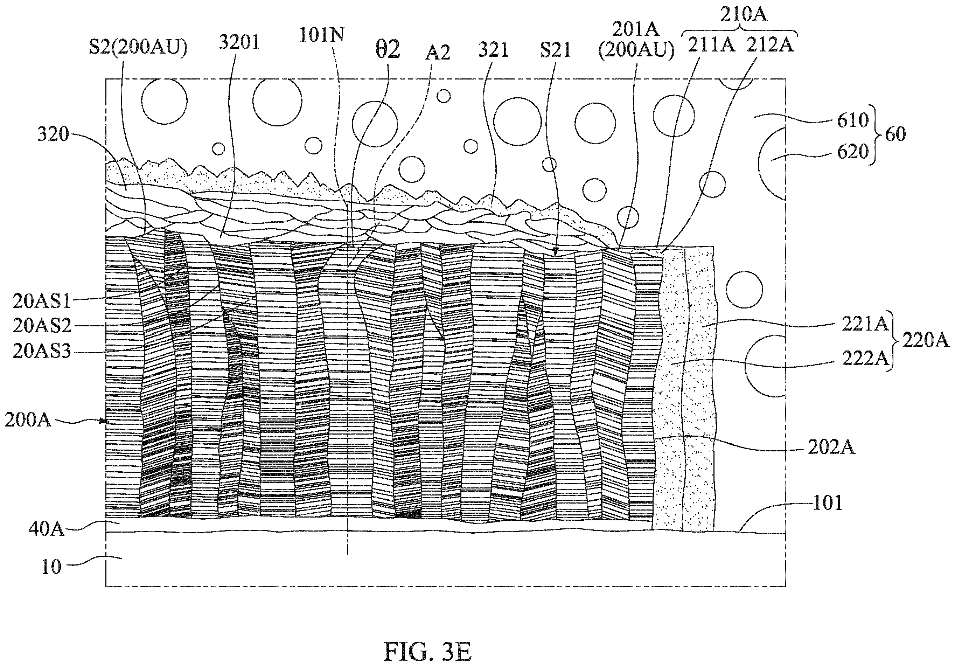

FIG. 3E is a cross-section of a portion of a package structure in accordance with some arrangements of the present disclosure.

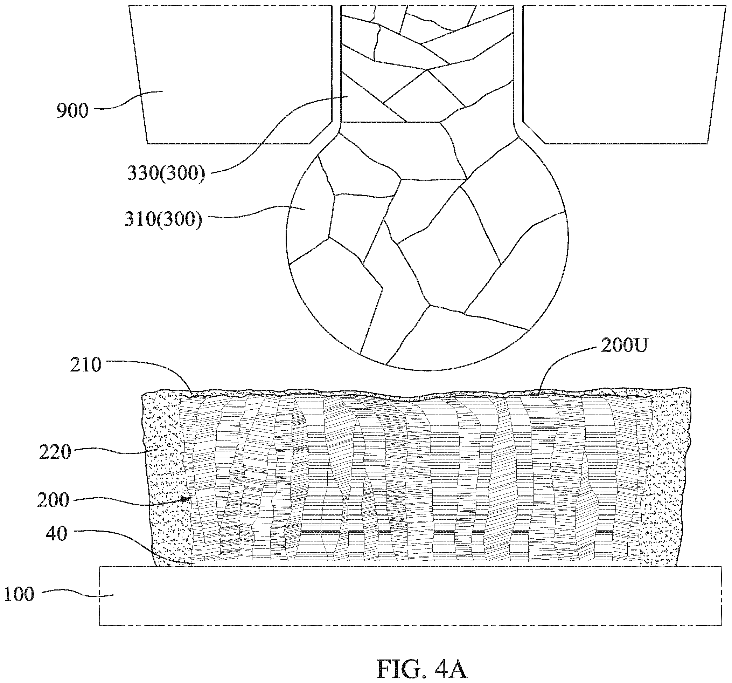

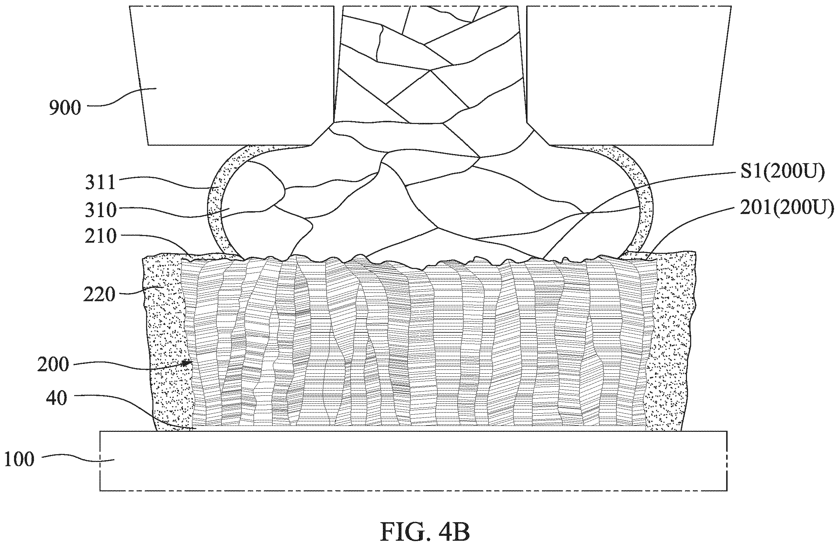

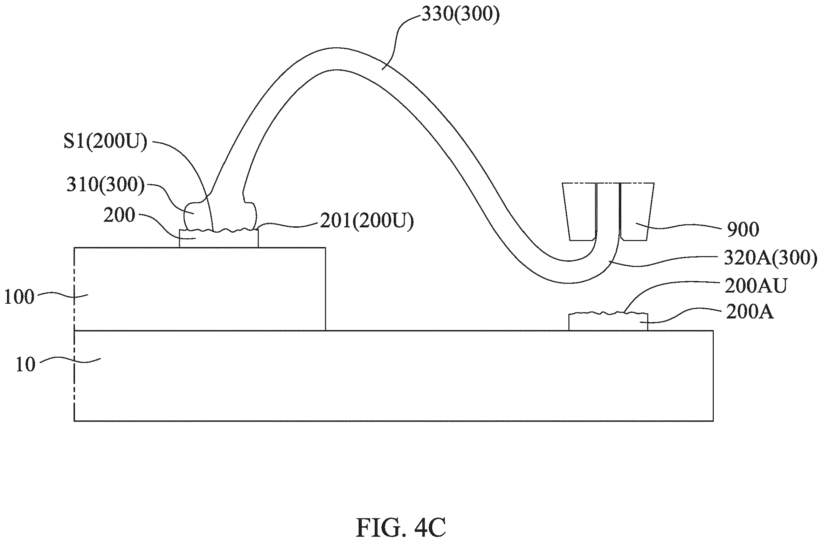

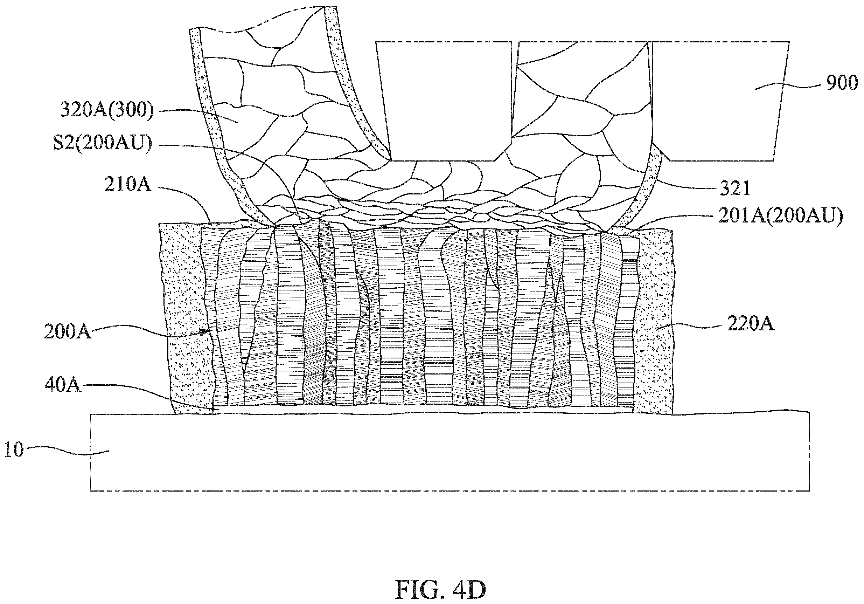

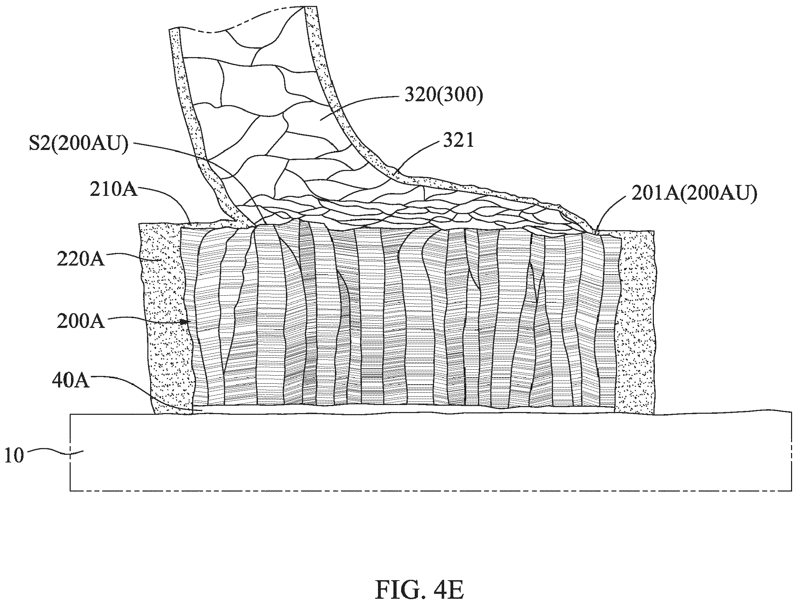

FIG. 4A, FIG. 4B, FIG. 4C, FIG. 4D, and FIG. 4E illustrate various stages of an example of a method for manufacturing a package structure in accordance with some arrangements of the present disclosure.

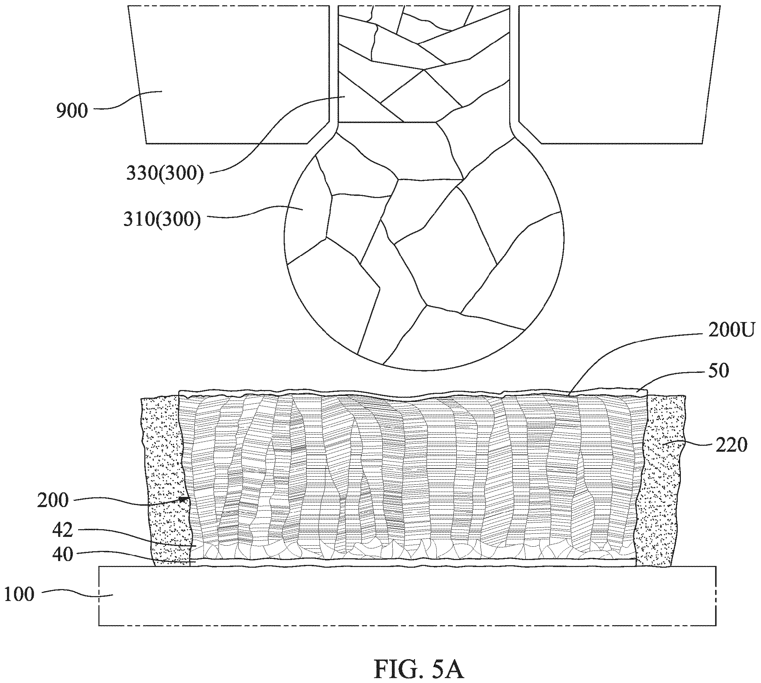

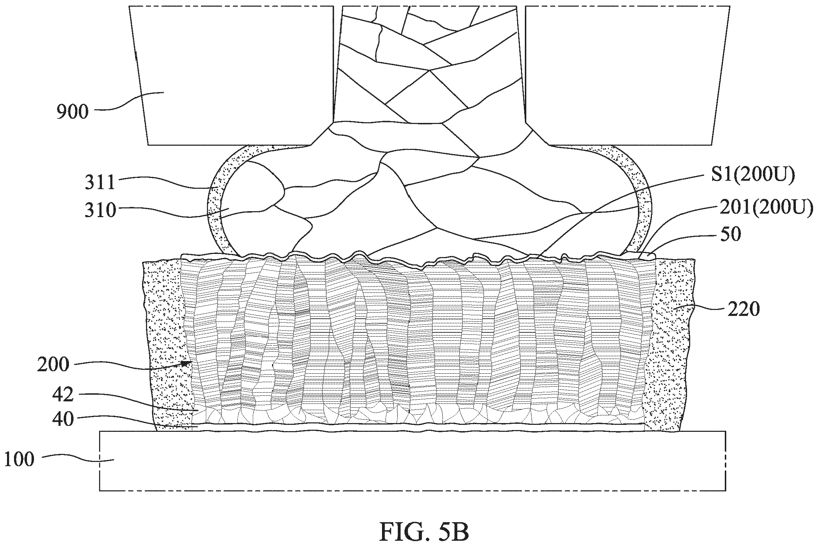

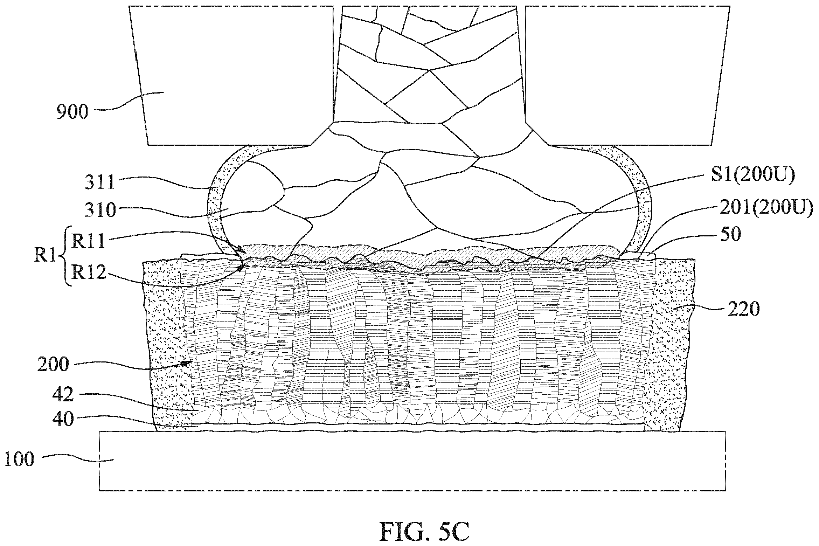

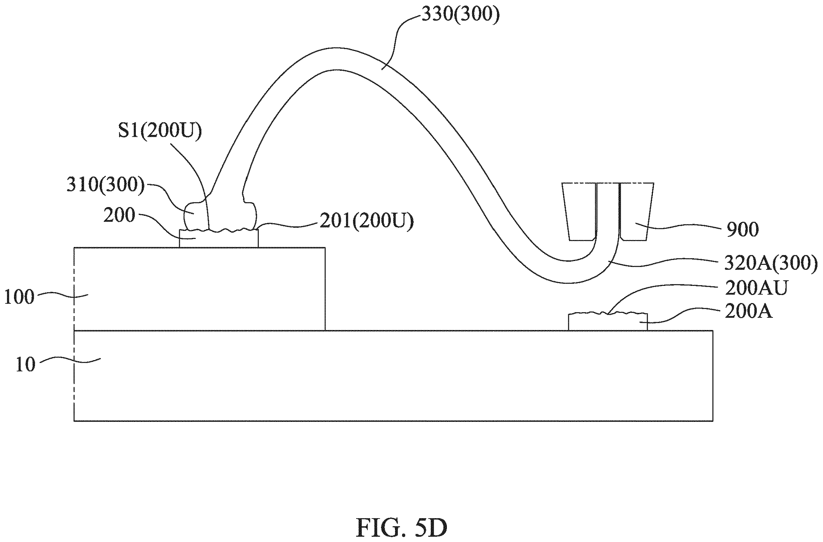

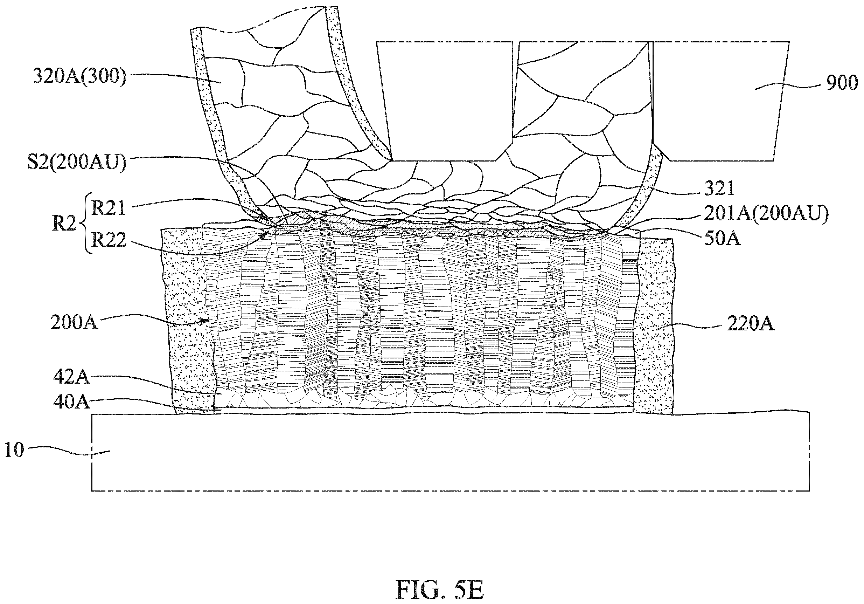

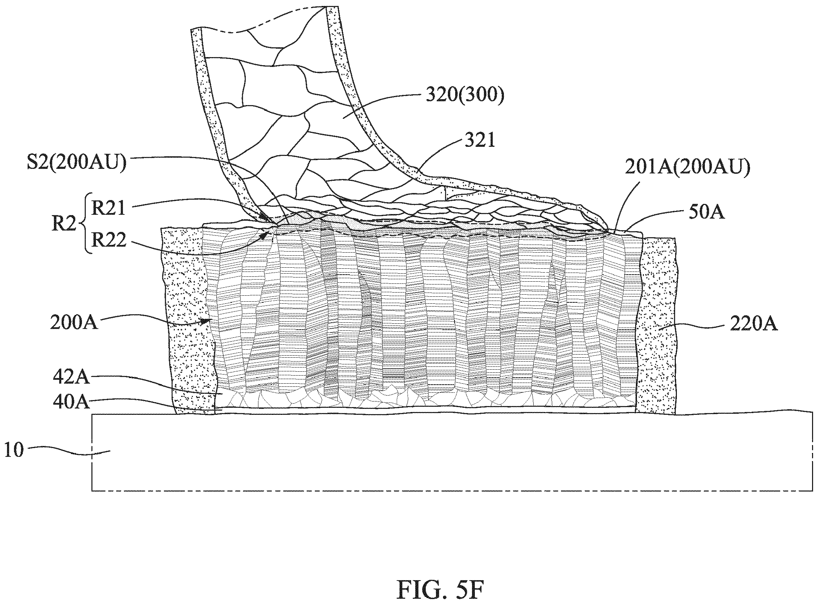

FIG. 5A, FIG. 5B, FIG. 5C, FIG. 5D, FIG. 5E, and FIG. 5F illustrate various stages of an example of a method for manufacturing a package structure in accordance with some arrangements of the present disclosure.

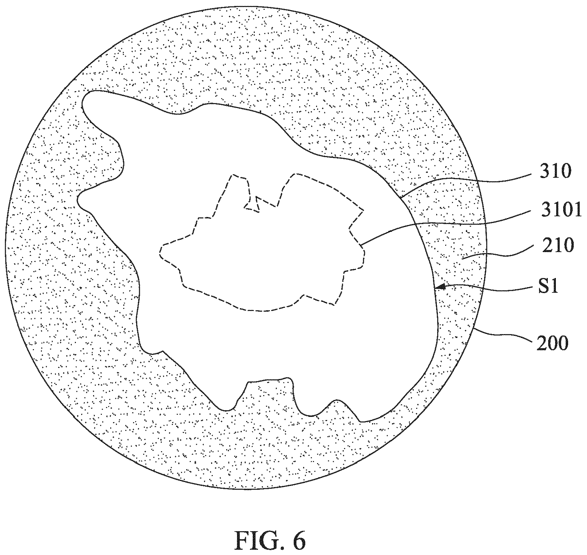

FIG. 6 is a schematic view of a portion of a package structure after a shear test is performed in accordance with some arrangements of the present disclosure.

Common reference numerals are used throughout the drawings and the detailed description to indicate the same or similar elements. The present disclosure will be more apparent from the following detailed description taken in conjunction with the accompanying drawings.

### DETAILED DESCRIPTION

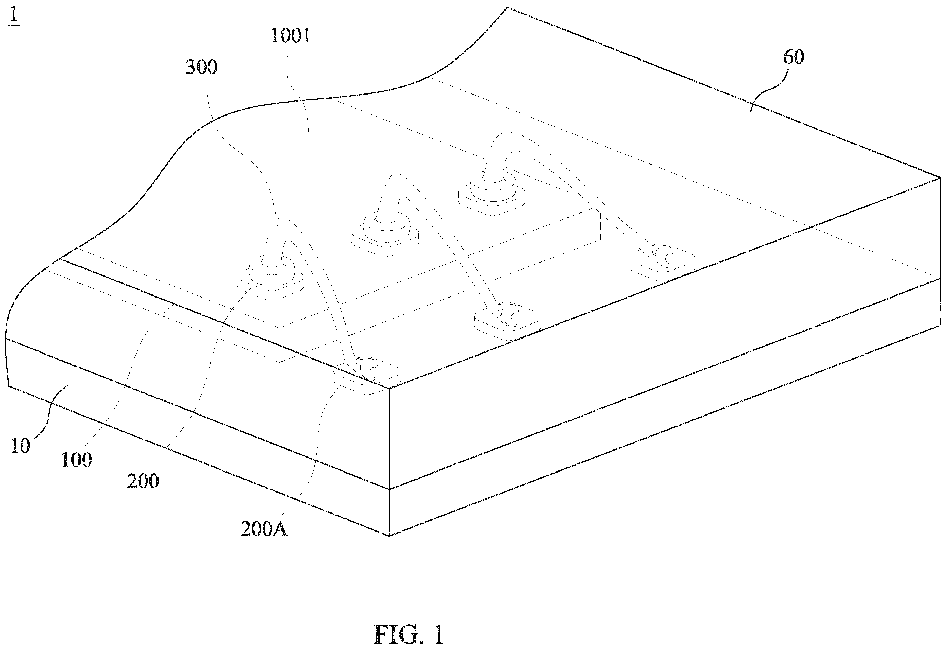

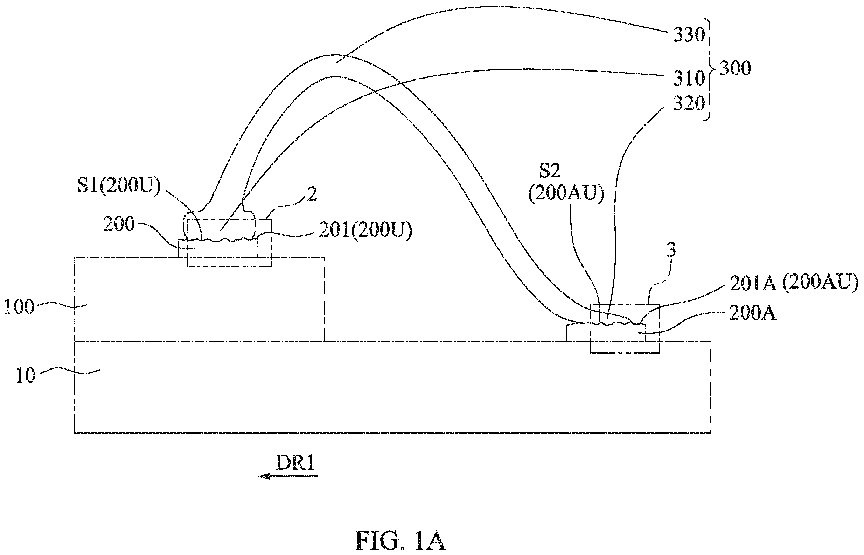

FIG. 1 is a schematic view of a package structure 1 in accordance with some arrangements of the present disclosure. FIG. 1A is a cross-section of a portion of a package structure 1 in accordance with some arrangements of the present disclosure. In some arrangements, FIG. 1A is a cross-section of a portion of the package structure 1 in FIG. 1. The package structure 1 may include substrates 10 and 100, conductive pads 200 and 200A, conductive wires 300, and an encapsulant 60.

The substrate 10 may include, for example, a printed circuit board, such as a paper-based copper foil laminate, a composite copper foil laminate, or a polymer-impregnated glass-fiber-based copper foil laminate. The substrate 10 may include an interconnection structure, such as a plurality of conductive traces and/or a plurality of conductive through vias. In some arrangements, the substrate 10 may include a ceramic material, a semiconductor material, and/or a metal material. For example, the substrate 10 may be or include a wafer (e.g., a silicon wafer), a silicon-based submount, an interposer (e.g., a glass interposer), a ceramic substrate, and/or a metal plate. In some arrangements, the substrate 10 may include an organic substrate or a leadframe. The leadframe may be or include a pre-molded leadframe. In some arrangements, the substrate 10 may include a two-layer substrate which includes a core layer and a conductive material and/or structure disposed on an upper surface and a bottom surface of the substrate 10. The conductive material and/or structure may include a plurality of conductive traces. The substrate 10 may include an electronic component. The electronic component may be a chip or a die including a semiconductor substrate, one or more integrated circuit devices and one or more overlying interconnection structures therein. The integrated circuit devices may include active devices such as transistors and/or passive devices such resistors, capacitors, inductors, or a combination thereof.

The substrate 100 may be disposed over the substrate 10. The substrate 100 may include, for example, a printed circuit board, such as a paper-based copper foil laminate, a composite copper foil laminate, or a polymer-impregnated glass-fiber-based copper foil laminate. The substrate 100 may include an interconnection structure, such as a plurality of conductive traces and/or a plurality of conductive through vias. In some arrangements, the substrate 100 may include a ceramic material, a semiconductor material, and/or a metal material. For example, the substrate 100 may be or include a wafer (e.g., a silicon wafer), a silicon-based submount, an interposer (e.g., a glass interposer), a ceramic substrate, and/or a metal plate. In some arrangements, the substrate 100 may include an organic substrate or a leadframe. The leadframe may be or include a pre-molded leadframe. In some arrangements, the substrate 100 may include a two-layer substrate which includes a core layer and a conductive material and/or structure disposed on an upper surface and a bottom surface of the substrate 100. The conductive material and/or structure may include a plurality of conductive traces. The substrate 100 may include an electronic component. The electronic component may be a chip or a die including a semiconductor substrate, one or more integrated circuit devices and one or more overlying interconnection structures therein. The integrated circuit devices may include active devices such as transistors and/or passive devices such resistors, capacitors, inductors, or a combination thereof.

Referring to FIGS. 1 and 1A, the conductive pad 200 may be disposed over the substrate 100. In some arrangements, the conductive pad 200 may have an anisotropic crystal structure. The anisotropic crystal structure may be or include a nanotwinned crystal structure. The term "nanotwinned" refers to two crystals (or two portions of a crystal) are formed mirrored across a common crystallographic plane. The nanotwinned crystal structure may include a plurality of grains each including a plurality of nanotwinned crystals (or "nanotwins", "nanotwinned layers", or "multi-layers") stacked in the common crystallographic plane. In some arrangements, the nanotwins (or the nanotwinned layers) area stacked in a direction from the substrate 100 toward the ball bond 310 (or the end portion). In some arrangements, the conductive pad 200 has a highly-oriented structure. In some arrangements, the conductive pad 200 may have a plurality of crystallographic planes, and the conductive pad 200 may have an upper surface 200U including a crystallographic plane having a maximum ion diffusion rate (or a maximum metal diffusion rate) among the plurality of crystallographic planes. In some arrangements, the conductive pad 200 is highly [111] oriented. In some arrangements, the conductive pad 200 includes a nanotwinned copper (NT-Cu) pad. In some arrangements, the conductive pad 200 is a NT-Cu pad including a [111] crystallographic plane, a [100] crystallographic plane, and a [110] crystallographic plane. At least one of the nanotwinned layers may have a [111] crystallographic plane facing the ball bond 310. In some arrangements, the conductive pad 200 is a NT-Cu pad with the upper surface 200U including a [111] crystallographic plane.

The conductive pad 200A may be disposed over the substrate 10. In some arrangements, the conductive pad 200A may have an anisotropic crystal structure. In some arrangements, the conductive pad 200A may have a plurality of crystallographic planes, and the conductive pad 200A may have an upper surface 200AU including a crystallographic plane having a maximum ion diffusion rate (or a maximum metal diffusion rate) among the plurality of crystallographic planes. In some arrangements, the conductive pad 200A is highly [111] oriented. In some arrangements, the conductive pad 200A includes a NT-Cu pad. In some arrangements, the conductive pad 200A is a NT-Cu pad including a [111] crystallographic plane, a [100] crystallographic plane, and a [110] crystallographic plane. In some arrangements, the conductive pad 200A is a NT-Cu pad with the upper surface 200AU including a [111] crystallographic plane.

The conductive wire 300 may be electrically connected to the conductive pad 200 and the conductive pad 200A. In some arrangements, the conductive wire 300 includes a ball bond 310 (also referred to as "an end portion"), a stitch bond 320, and a wire portion 330 connecting the ball bond 310 to the stitch bond 320.

In some arrangements, the ball bond 310 is electrically connected to the conductive pad 200. In some arrangements, the ball bond 310 directly connects to or directly contacts the conductive pad 200. In some arrangements, the ball bond 310 is connected to the crystallographic plane having the maximum ion diffusion rate (or the maximum metal diffusion rate) of the conductive pad 200. In some arrangements, the ball bond 310 is connected to the [111] crystallographic plane of the conductive pad 200 (e.g., the NT-Cu pad). In some arrangements, the ball bond 310 of the conductive wire 300 directly contacts a portion (i.e. an interface S1 between the ball bond 310 and the conductive pad 200) of the upper surface 200U and exposes a portion 201 of the upper surface 200U.

In some arrangements, the stitch bond 320 is electrically connected to the conductive pad 200A. In some arrangements, the stitch bond 320 directly connects to or directly contacts the conductive pad 200A. In some arrangements, the stitch bond 320 is connected to the crystallographic plane having the maximum ion diffusion rate (or the maximum metal diffusion rate) of the conductive pad 200A. In some arrangements, the stitch bond 320 is connected to the [111] crystallographic plane of the conductive pad 200A (e.g., the NT-Cu pad). In some arrangements, the stitch bond 320 of the conductive wire 300 directly contacts a portion (i.e. an interface S2 between the stitch bond 320 and the conductive pad 200A) of the upper surface 200AU and exposes a portion 201A of the upper surface 200AU.

In some arrangements, the conductive wire 300 is configured not to form an intermetallic compound (IMC) at the interface S1 between the conductive wire 300 (e.g., the ball bond 310) and the conductive pad 200. In some arrangements, the conductive wire 300 is configured not to form an IMC at the interface S2 between the conductive wire 300 (e.g., the stitch bond 320) and the conductive pad 200A. In some arrangements, the conductive wire 300 is configured not to form a void at the interface S1 between the conductive wire 300 (e.g., the ball bond 310) and the conductive pad 200. In some arrangements, the conductive wire 300 is configured not to form a void at the interface S2 between the conductive wire 300 (e.g., the stitch bond 320) and the conductive pad 200A. In some arrangements, a shear strength in the conductive wire 300 is less than a shear strength at the interface S1 between the conductive wire 300 (e.g., the ball bond 310) and the conductive pad 200. In some arrangements, a shear strength in the conductive wire 300 is less than a shear strength at the interface S2 between the conductive wire 300 (e.g., the stitch bond 320) and the conductive pad 200A.

The encapsulant 60 may encapsulate an upper surface 101 of the substrate 10, the substrate 100, the conductive pads 200 and 200A, and the conductive wires 300. The encapsulant 60 may include an epoxy resin having fillers (not shown in FIGS. 1 and 1A), a molding compound (e.g., an epoxy molding compound or other molding compound), polyimide, a phenolic compound or material, a material with silicone dispersed therein, or a combination thereof.

FIG. 2A is a cross-section of a portion of a package structure in accordance with some arrangements of the present disclosure. In some arrangements, FIG. 2A is a cross-section of a portion 2 of the package structure 1 in FIG. 1.

In some arrangements, the conductive pad 200 includes a plurality of crystal grains (e.g., crystal grains 2001, 2002, 2003, 2004, and 2005). The crystal grains may be referred to grains. The crystal grains 2001, 2002, 2003, 2004, and 2005 of the conductive pad 200 may include columnar shapes. The crystal grains 2001, 2002, 2003, 2004, and 2005 of the conductive pad 200 may be referred to as columnar grains. The crystal grains 2001, 2002, 2003, 2004, and 2005 of the conductive pad 200 may extend upwards. In some arrangements, the conductive pad 200 includes a plurality of grain boundaries (e.g., grain boundaries 20S1, 20S2, and 20S3). A width of one columnar grain (e.g., a distance between adjacent grain boundaries) may be about 3 µm to about 5 µm. In some arrangements, one or more of the crystal grains 2001, 2002, 2003, 2004, and 2005 may include a plurality of nanotwins stacked along a [111] crystal axis (e.g., an axis A1). The axis A1 may be referred to a first direction. Each of the layers (or the nanotwins) in the crystal grain (e.g., the crystal grain 2001) illustrated in FIG. 2A may be a nanotwinned crystal or include a plurality of sets of nanotwinned crystals. Each of the layers (or the nanotwins) may have a twin spacing (e.g., a thickness of a layer) of about 40 nm to about 100 nm. In some arrangements, an angle θ1 defined by the [111] crystal axis (i.e., the axis A1) and a normal line 101N to an upper surface 1001 of the substrate 100 may be greater than 0°. In some arrangements, the crystal grains (e.g., the crystal grains 2001, 2002, 2003, 2004, and 2005) of the conductive pad 200 bend toward a substantially same direction DR1 with respect to the normal line 101N. In some arrangements, referring to FIGS. 1A and 2A, the crystal grains (e.g., the crystal grains 2001, 2002, 2003, 2004, and 2005) of the conductive pad 200 bend toward away from the wire portion 330 of the conductive wire 300. In some arrangements, the crystal grain 2001 includes a curved portion 2001C1 (also referred to as "an upstanding portion") proximal to the substrate 100 and a curved portion 2001C2 (also referred to as "a bending portion") proximal to the ball bond 310 (or the end portion of the conductive wire 300), and the curved portion 2001C2 (or the upstanding portion) is more curved than the curved portion 2001C1 (or the bending portion). In some arrangements, the curved portion 2001C2 is more inclined than the cured portion 2001C1 with respect to the substrate 100 in a cross-sectional view. In some arrangements, a curvature of the curved portion 2001C2 is less than a curvature of the curved portion 2001C1. In some arrangements, the crystal grain 2005 includes a curved portion 2005C (also referred to as "a bending portion") at a lateral side of the crystal grain 2001, and the curved portion 2001C2 is more curved or inclined than the curved portion 2005C in a cross-sectional view. In some arrangements, the crystal grain 200 further includes an upstanding portion on which the curved portion 2005C (or the bending portion) is over, and the curved portion 2005C (or the bending portion) is more inclined than the upstanding portion of the crystal grain 2005 with respect to the substrate 100 in a cross-sectional view. In some arrangements, the curved portion 2001C2 is more inclined than the curved portion 2005C. In some arrangements, a curvature of the curved portion 2001C2 is less than a curvature of the curved portion 2005C. In some arrangements, the crystal grain 2005 is spaced apart from the ball bond 310. In some arrangements, the crystal grain 2005 is not in contact with the ball bond 310. In some arrangements, the curved portion 2001C2 contacts the ball bond 310, and the curved portion 2005C is spaced apart from the ball bond 310.

In some arrangements, the conductive wire 300 includes a plurality of crystal grains (e.g., crystal grains 3101, 3102, 3103, 3104, and 3105). In some arrangements, the ball bond 310 of the conductive wire 300 includes a plurality of crystal grains (e.g., the crystal grains 3101, 3102, 3103, 3104, and 3105). In some arrangements, at least one of the crystal grains (e.g., the crystal grain 3101) defines a portion of the interface S1 between the conductive wire 300 and the conductive pad 200 and connects to a plurality of grain boundaries (e.g., the grain boundaries 20S1, 20S2, and 20S3) of the conductive pad 200. In some arrangements, the crystal grain 3101 defines a portion of the interface S1 between the ball bond 310 and the conductive pad 200. In some arrangements, the crystal grain 3101 contacts a plurality of the columnar crystal grains (e.g., the crystal grains 2001, 2002, 2003, 2004, and 2005) of the conductive pad 200. In some arrangements, at least a crystal grain of the ball bond 310 contacts the [111] crystallographic plane of the conductive pad 200. In some arrangements, at least a crystal grain (e.g., the crystal grain 3101) of the ball bond 310 contacts one or more interfaces between the nanotwinned layers of the conductive pad 200. In some arrangements, at least a crystal grain (e.g., the crystal grain 3101) of the ball bond 310 is at least partially between at least two crystal grains (e.g., the crystal grains 2002 and 2003) of the conductive pad 200. In some arrangements, at least a crystal grain (e.g., the crystal grain 3101) of the ball bond 310 contacts [111] crystallographic planes of at least two crystal grains (e.g., the crystal grains 2002 and 2003) of the conductive pad 200. In some arrangements, a size of the crystal grain of the ball bond 310 is greater than a size of the crystal grain of the conductive pad 200.

In some arrangements, the conductive pad 200 and the conductive wire 300 (e.g., the ball bond 310) include a same metal material, and the conductive pad 200 and the conductive wire 300 (e.g., the ball bond 310) include different grain structures. In some arrangements, a crystal grain arrangement of the ball bond 310 (or the end portion) is distinct from a crystal grain arrangement of the conductive pad 200. In some arrangements, the arrangement of the crystal grains of the ball bond 310 is distinct or different from the arrangement of the crystal grains of the conductive pad 200. In some arrangements, the conductive wire 300 has a substantially isotropic crystal structure, and the conductive pad 200 has an anisotropic crystal structure. In some arrangements, the conductive wire 300 includes copper (Cu), and the conductive pad 200 is or includes a NT-Cu pad.

In some arrangements, the upper surface 200U of the conductive pad 200 has a portion 201 (also referred to as "an upper surface portion") exposed by the conductive wire 300 (e.g., the ball bond 310), and the interface S1 has a recess portion S11 recessed with respect to the portion 201 of the upper surface 200U of the conductive pad 200. In some arrangements, the crystal grain 3101 of the conductive wire 300 (or the ball bond 310) partially extends toward the recess portion S11 of the interface S1. In some arrangements, the recess portion S11 is recessed from the portion 201 of the upper surface 200U by a depth D1. In some arrangements, a portion of the ball bond 310 extends toward the recess portion S11.

In some arrangements, the package structure 1 may further include an oxide layer 210 over the [111] crystallographic plane of the conductive pad 200. In some arrangements, the oxide layer 210 directly contacts the portion 201 of the upper surface 200U. In some arrangements, the oxide layer 210 directly contacts a portion (e.g., the ball bond 310) of the conductive wire 300. In some arrangements, the conductive wire 300 is spaced apart from the portion 201 of the upper surface 200U by the oxide layer 210. In some arrangements, the oxide layer 210 contacts the ball bond 310. In some arrangements, the conductive wire 300 (or the ball bond 310) penetrates the oxide layer 210 to directly contact the anisotropic crystal structure of the conductive pad 200. In some arrangements, the conductive pad 200 is a NT-Cu pad, and the oxide layer 210 is over the [111] crystallographic plane of the NT-Cu pad. In some arrangements, the conductive wire 300 (or the ball bond 310) penetrates the oxide layer 210 to directly contact the [111] crystallographic plane of the NT-Cu pad. In some arrangements, the oxide layer 210 may be referred to as a protective layer. In some arrangements, the oxide layer 210 may be configured to prevent the conductive pad 200 from being further oxidized and consumed by oxidation. In some arrangements, the oxide layer 210 includes a native oxide of the conductive pad 200. In some arrangements, the oxide layer 210 is or includes a native oxide layer grown from the [111] crystallographic plane of the NT-Cu pad (i.e., the conductive pad 200). In some arrangements, the oxide layer 210 includes copper oxide. In some arrangements, the oxide layer 210 includes CuO and Cu₂O.

In some arrangements, the package structure 1 may further include an oxide layer 220 over a non-[1 11] crystallographic plane of the conductive pad 200. The oxide layer 220 may be on a lateral side of the [111] crystallographic plane. In some arrangements, the oxide layer 220 directly contacts a lateral surface 202 of the conductive pad 200. In some arrangements, the thickness T1 of the oxide layer 210 is less than a thickness T3 of the oxide layer 220. In some arrangements, the conductive pad 200 is a NT-Cu pad, and the oxide layer 220 is over a non-[1 11] crystallographic plane of the NT-Cu pad. In some arrangements, the oxide layer 220 includes a native oxide of the conductive pad 200. In some arrangements, the oxide layer 220 is or includes a native oxide layer grown from the non-[1 11] crystallographic plane of the NT-Cu pad (i.e., the conductive pad 200). The oxide layers 210 and 220 collectively may be referred to as an oxide layer or a monolithic oxide layer. The oxide layers 210 and 220 may be formed integrally. The oxide layers 210 and 220 may be a monolithic native oxide layer of the conductive pad 200. The oxide layer 210 may be referred to as a first portion of the oxide layer (or the monolithic oxide layer), and the oxide layer 220 may be referred to as a second portion of the oxide layer (or the monolithic oxide layer).

In some arrangements, the package structure 1 may further include an oxide layer 311 on the ball bond 310 of the conductive wire 300. The oxide layer 311 may cover the conductive wire 300 (or the ball bond 310). In some arrangements, an interface S311 between the oxide layer 311 and the conductive wire 300 is directly connected to an interface S210 between the oxide layer 210 and the conductive wire 300. In some arrangements, the oxide layer 311 includes a native oxide of the ball bond 310 of the conductive wire 300. In some arrangements, the thickness T1 of the oxide layer 210 is less than a thickness T2 of the oxide layer 311.

In some arrangements, the package structure 1 may further include a seed layer 40. The seed layer 40 may include Cu, a Cu alloy, or any applicable seed layer material. The seed layer 40 may be disposed or plated on the upper surface 1001 of the substrate 100, and the conductive pad 200 may be disposed or formed on the seed layer 40.

In some arrangements, the encapsulant 60 includes a resin layer 610 and fillers 620 dispersed in the resin layer 610. In some arrangements, the fillers 620 may include a material the same as a material of the substrate 100. For example, the fillers 620 may include a semiconductor material, e.g., silicon.

FIG. 2A1 is a cross-section of a portion of a package structure in accordance with some arrangements of the present disclosure. In some arrangements, FIG. 2A is a cross-section of a portion 2A1 of the structure in FIG. 2A.

In some arrangements, the conductive pad 200 may include an oxide layer 210N (e.g., native oxides of the conductive pad 200) within or embedded in the anisotropic crystal structure of the conductive pad 200. In some arrangements, a thickness T4 of the oxide layer 210N is less than the thickness T1 of the oxide layer 210. In some arrangements, the oxide layer 210N is adjacent to an interface between the oxide layer 210 and the portion 201 of the upper surface 200U of the conductive pad 200. In some arrangements, the oxide layer 210N may extend between the grains of the conductive pad 200. A portion of the oxide layer 210N may be formed along grain boundaries of the columnar grains of the conductive pad 200. A portion of the oxide layer 210N may be formed along boundaries of the nanotwinned crystals (or the nanotwins). With the nanotwined crystal structure of the conductive pad 200 having a relatively dense structure, the oxide layer 210N may be formed along a portion of the grain boundaries proximal to the upper surface 200U. In some arrangements, a gap between two adjacent crystal grains of the ball bond 310 is greater than a gap between the crystal grains of the conductive pad 200. The gap may be referred to as a grain boundary between crystal grains.

FIG. 2B is a cross-section of a portion of a package structure in accordance with some arrangements of the present disclosure. In some arrangements, FIG. 2B is a cross-section of a portion 2 of the package structure 1 in FIG. 1. The structure illustrated in FIG. 2B is similar to that in FIG. 2A, and the differences therebetween are described as follows.

In some arrangements, the package structure 1 may further include a protective layer 50 over the [111] crystallographic plane of the conductive pad 200. In some arrangements, the protective layer 50 directly contacts the portion 201 of the upper surface 200U. In some arrangements, the protective layer 50 directly contacts a portion (e.g., the ball bond 310) of the conductive wire 300. In some arrangements, the conductive wire 300 is spaced apart from the portion 201 of the upper surface 200U by the protective layer 50. In some arrangements, the conductive pad 200 is a NT-Cu pad, and the protective layer 50 is over the [111] crystallographic plane of the NT-Cu pad. In some arrangements, the conductive wire 300 (or the ball bond 310) penetrates the protective layer 50 to directly contact the [111] crystallographic plane of the NT-Cu pad. In some arrangements, the protective layer 50 may be configured to prevent the conductive pad 200 from being oxidized or consumed by oxidation. In some arrangements, the protective layer 50 includes a metal material configured not to form an IMC with the conductive wire 300 and the conductive pad 200. In some arrangements, the conductive pad 200 is or includes a NT-Cu pad, and the protective layer 50 includes Au, Ni, Pd, other applicable metal materials, an alloy thereof, or a combination thereof.

In some arrangements, the package structure 1 may further include an alloy solid solution region R1 around a portion (e.g., the interface S1) of the upper surface 200U of the conductive pad 200. In some arrangements, a portion of the alloy solid solution region R1 is exposed to the protective layer 50. In some arrangements, the alloy solid solution region R1 includes a region R11 including an alloy solid solution of the protective layer 50 and the conductive wire 300. In some arrangements, the alloy solid solution region R1 includes a region R12 including an alloy solid solution of the protective layer 50 and the conductive pad 200.

In some arrangements, an interface S311 between the oxide layer 311 and the conductive wire 300 is directly connected to an interface S50 between the protective layer 50 and the alloy solid solution region R1.

In some arrangements, the package structure 1 may further include a transition layer 42 between the seed layer 40 and the conductive pad 200. The transition layer 42 may include a polycrystal layer. In some arrangements, the transition layer 42 includes a plurality of crystal grains that have a size less than that of the crystal grains of the ball bond 310. In some arrangements, the conductive pad 200 and the transition layer 42 include a same metal material. In some arrangements, the transition layer 42 includes Cu.

FIG. 2C is a cross-section of a portion of a package structure in accordance with some arrangements of the present disclosure. In some arrangements, FIG. 2C is a cross-section of a portion 2 of the package structure 1 in FIG. 1. The structure illustrated in FIG. 2C is similar to that in FIG. 2A, and the differences therebetween are described as follows.

In some arrangements, the substrate 100 includes a recess 110R, and the conductive pad 200 is disposed within the recess 110R. In some arrangements, the substrate 100 includes a base layer 100A and a dielectric layer 110 over the base layer 100A. In some arrangements, the lateral surface 202 of the conductive pad 200 directly contacts a sidewall of the recess 110R. The lateral surface 202 of the conductive pad 200 may be substantially flat. The lateral surface 202 of the conductive pad 200 may be defined by and conformal with the sidewall of the recess 110R. In some arrangements, the portion 201 of the upper surface 200U is substantially aligned with an upper surface 1101 of the dielectric layer 110.

FIG. 2D is a cross-section of a portion of a package structure in accordance with some arrangements of the present disclosure. In some arrangements, FIG. 2D is a cross-section of a portion 2 of the package structure 1 in FIG. 1. The structure illustrated in FIG. 2D is similar to that in FIG. 2A, and the differences therebetween are described as follows.

In some arrangements, the lateral surface 202 of the conductive pad 200 is substantially flat. The substantially flat morphology of the lateral surface 202 may be defined by a photoresist layer during the manufacturing process, and the photoresist has been removed after the conductive pad 200 has been formed in the manufacturing process.

In some arrangements, the conductive pad 200 and the conductive wire 300 include different materials. In some arrangements, the conductive wire 300 includes a metal material configured to form an alloy solid solution with the conductive pad 200. In some arrangements, the conductive pad 200 includes a first metal material M1, and the conductive wire 300 includes a second metal material M2 configured to form an alloy solid solution with the first metal material M1. In some arrangements, the alloy solid solution region R1 includes an alloy solid solution of the conductive wire 300 and the conductive pad 200. In some arrangements, the alloy solid solution region R1 includes a region R11 and a region R12 having different alloy compositions. In some arrangements, a concentration of the first metal material M1 in the region R11 is less than a concentration of the second metal material M2 in the region R11. In some arrangements, a concentration of the first metal material M1 in the region R12 is greater than a concentration of the second metal material M2 in the region R12. In some arrangements, the conductive pad 200 is or includes a NT-Cu pad, and the conductive wire 300 includes a gold (Au) wire, a Cu wire including less than about 1% of Au, a palladium (Pd) coated Cu wire, or a Cu wire including less than about 1% of Pd.

FIG. 2E is a cross-section of a portion of a package structure in accordance with some arrangements of the present disclosure. In some arrangements, FIG. 2E is a cross-section of a portion 2 of the package structure 1 in FIG. 1. The structure illustrated in FIG. 2E is similar to that in FIG. 2A, and the differences therebetween are described as follows.

In some arrangements, the oxide layer 210 includes sub-oxide layers 211 and 212. The sub-oxide layers 211 and 211 may have different ratios of metal atoms to oxygen atoms. In some arrangements, a ratio of metal atoms to oxygen atoms of the sub-oxide layer 212 is greater than a ratio of metal atoms to oxygen atoms of the sub-oxide layer 211. In some arrangements, the sub-oxide layer 211 includes CuO, and the sub-oxide layer 212 includes Cu₂O. In some arrangements, a thickness of the sub-oxide layer 211 is less than a thickness of the sub-oxide layer 212.

In some arrangements, the oxide layer 220 includes sub-oxide layers 221 and 222. The sub-oxide layers 221 and 222 may have different ratios of metal atoms to oxygen atoms. In some arrangements, a ratio of metal atoms to oxygen atoms of the sub-oxide layer 222 is greater than a ratio of metal atoms to oxygen atoms of the sub-oxide layer 221. In some arrangements, the sub-oxide layer 221 includes CuO, and the sub-oxide layer 222 includes Cu₂O. In some arrangements, a thickness of the sub-oxide layer 221 is less than a thickness of oxide layer 210. In some arrangements, a thickness of the sub-oxide layer 222 is less than a thickness of oxide layer 210. In some arrangements, the thickness of the sub-oxide layer 222 is greater than the thickness of the sub-oxide layer 212. In some arrangements, the thickness of the sub-oxide layer 221 is greater than the thickness of the sub-oxide layer 211.

FIG. 3A is a cross-section of a portion of a package structure in accordance with some arrangements of the present disclosure. In some arrangements, FIG. 3A is a cross-section of a portion 3 of the package structure 1 in FIG. 1.

In some arrangements, the conductive pad 200A includes a plurality of crystal grains (e.g., crystal grains 2001A, 2002A, 2003A, 2004A, 2005A, and 2006A). The crystal grains 2001A, 2002A, 2003A, 2004A, 2005A, and 2006A of the conductive pad 200A may include columnar shapes. The crystal grains 2001A, 2002A, 2003A, 2004A, 2005A, and 2006A of the conductive pad 200A may be referred to as columnar grains. In some arrangements, the conductive pad 200A includes a plurality of grain boundaries (e.g., grain boundaries 20AS1, 20AS2, and 20AS3). A width of one columnar grain (e.g., a distance between adjacent grain boundaries) may be about 3 µm to about 5 µm. In some arrangements, one or more of the crystal grains 2001A, 2002A, 2003A, 2004A, 2005A, and 2006A may include a plurality of nanotwins stacked along a [111] crystal axis (e.g., an axis A2). The axis A2 may be referred to a first direction. In some arrangements, an angle θ2 defined by the [111] crystal axis (i.e., the axis A2) and the normal line 101N to the upper surface 1001 (not shown in FIG. 3A) of the substrate 100 may be greater than 0°. In some arrangements, the angle θ1 defined by the axis A1 and the normal line 101N is greater than angle θ2 defined by the axis A2 and the normal line 101N. In some arrangements, the axis A1 and the axis A2 extend in different directions. In some arrangements, the axis A1 is more inclined than the axis A2 with respect to the substrate 100. In some arrangements, the crystal grain (or the columnar grain) of the conductive pad 200 includes a bent portion adjacent to the interface S1, and the crystal grain (or the columnar grain) of the conductive pad 200A includes a bent portion adjacent to the interface S2. In some arrangements, a curvature of the bent portion of the conductive pad 200 is less than a curvature of the bent portion of the conductive pad 200A. In some arrangements, the bent portion of the conductive pad 200 is more sharply bent than the bent portion of the conductive pad 200A. The more sharply bent portion of the conductive pad 200 may be resulted from the relatively large force applied on the conductive pad 200 when bonding the conductive wire 300 to the conductive pad 200. In some arrangements, the crystal grains of the conductive pad 200A include curved portions (e.g., curved portions 2001AC and 2005AC). In some arrangements, the crystal grain 2001 includes the curved portion 2001AC adjacent to the interface S2, and the crystal grain 2005 includes the curved portion 2005AC adjacent to the interface S2. In some arrangements, the curved portion 2001C2 of the crystal grain 2001 of the ball bond 310 is more curved than the curved portions 2001AC and 2005AC of the crystal grains of the conductive pad 200A.

In some arrangements, the conductive wire 300 includes a plurality of crystal grains (e.g., crystal grains 3201, 3202, 3203, and 3204). In some arrangements, the stitch bond 320 of the conductive wire 300 includes a plurality of crystal grains (e.g., the crystal grains 3201, 3202, 3203, and 3204). In some arrangements, at least one of the crystal grains (e.g., the crystal grain 3201) defines a portion of the interface S2 between the conductive wire 300 and the conductive pad 200A and connects to a plurality of grain boundaries (e.g., the grain boundaries 20AS1, 20AS2, and 20AS3) of the conductive pad 200A. In some arrangements, the crystal grain 3201 defines a portion of the interface S2 between the stitch bond 320 and the conductive pad 200A. In some arrangements, the crystal grain 3201 contacts a plurality of the columnar crystal grains (e.g., the crystal grains 2003A, 2004A, 2005A, and 2006A) of the conductive pad 200A.

In some arrangements, the crystal grain of the stitch bond 320 has an aspect ratio greater than that of the crystal grain of the ball bond 310. In some arrangements, a thickness of the crystal grain of the stitch bond 320 is less than a thickness of the crystal grain of the ball bond 310 in a vertical direction. In some arrangements, a size of the crystal grain of the stitch bond 320 is less than a size of the crystal grain of the ball bond 310.

In some arrangements, the conductive pad 200A and the conductive wire 300 (e.g., the stitch bond 320) include a same metal material, and the conductive pad 200A and the conductive wire 300 (e.g., the stitch bond 320) include different grain structures. In some arrangements, the conductive wire 300 (e.g., the stitch bond 320) is configured not to form an IMC at the interface S2 between the stitch bond 320 and the conductive pad 200A. In some arrangements, the conductive wire 300 includes Cu, and the conductive pad 200A is or includes a NT-Cu pad.

In some arrangements, the upper surface 200AU of the conductive pad 200A has a portion 201A (also referred to as "an upper surface portion") exposed by the conductive wire 300 (e.g., the stitch bond 320), and the interface S2 has a recess portion S21 recessed with respect to the portion 201A of the upper surface 200AU of the conductive pad 200A. In some arrangements, the crystal grain 3204 of the conductive wire 300 (or the stitch bond 320) partially extends toward the recess portion S21 of the interface S2. In some arrangements, the recess portion S21 is recessed from the portion 201A of the upper surface 200AU by a depth D2. In some arrangements, a portion of the stitch bond 320 extends toward the recess portion S21. In some arrangements, the depth D2 of the recess portion 21 of the interface S2 is less than the depth D1 of the recess portion S11 of the interface S1. In some arrangements, a boundary roughness (e.g., the surface roughness of the interface S1) between the ball bond 310 and the conductive pad 200 is greater than a boundary roughness (e.g., the surface roughness of the interface S2) between the stitch bond 320 and the conductive pad 200A.

In some arrangements, the package structure 1 may further include an oxide layer 210A over the [111] crystallographic plane of the conductive pad 200A. In some arrangements, the oxide layer 210A directly contacts the portion 201A of the upper surface 200AU. In some arrangements, the oxide layer 210A directly contacts a portion (e.g., the stitch bond 320) of the conductive wire 300. In some arrangements, the conductive pad 200A is a NT-Cu pad, and the oxide layer 210A is over the [111] crystallographic plane of the NT-Cu pad. In some arrangements, the conductive wire 300 (or the stitch bond 320) penetrates the oxide layer 210A to directly contact the [111] crystallographic plane of the NT-Cu pad. In some arrangements, the oxide layer 210A may be referred to as a protective layer. In some arrangements, the oxide layer 210A may be configured to prevent the conductive pad 200A from being further oxidized and consumed by oxidation. In some arrangements, the oxide layer 210A includes a native oxide of the conductive pad 200A. In some arrangements, the oxide layer 210A is or includes a native oxide layer grown from the [111] crystallographic plane of the NT-Cu pad (i.e., the conductive pad 200A). In some arrangements, the oxide layer 210A includes copper oxide. In some arrangements, the oxide layer 210A includes CuO and Cu₂O.

In some arrangements, the package structure 1 may further include an oxide layer 220A over a non-[111] crystallographic plane of the conductive pad 200A. In some arrangements, the oxide layer 220A directly contacts a lateral surface 202A of the conductive pad 200A. In some arrangements, a thickness T1A of the oxide layer 210A is less than a thickness T3A of the oxide layer 220A. In some arrangements, the conductive pad 200A is a NT-Cu pad, and the oxide layer 220A is over a non-[111] crystallographic plane of the NT-Cu pad. In some arrangements, the oxide layer 220A includes a native oxide of the conductive pad 200A. In some arrangements, the oxide layer 220A is or includes a native oxide layer grown from the non-[111] crystallographic plane of the NT-Cu pad (i.e., the conductive pad 200A).

In some arrangements, the package structure 1 may further include an oxide layer 321 on the stitch bond 320 of the conductive wire 300. In some arrangements, the oxide layer 321 includes a native oxide of the stitch bond 320 of the conductive wire 300. In some arrangements, the thickness T1A of the oxide layer 210A is less than a thickness T2A of the oxide layer 321.

In some arrangements, the package structure 1 may further include a seed layer 40A. The seed layer 40A may include Cu, a Cu alloy, or any applicable seed layer material. The seed layer 40A may be disposed or plated on the upper surface 101 of the substrate 10, and the conductive pad 200A may be disposed or formed on the seed layer 40A.

FIG. 3A1 is a cross-section of a portion of a package structure in accordance with some arrangements of the present disclosure. In some arrangements, FIG. 3A is a cross-section of a portion 3A1 of the structure in FIG. 3A.

In some arrangements, the conductive pad 200A may include an oxide layer 210AN (e.g., native oxides of the conductive pad 200A) adjacent to an interface between the oxide layer 210A and the portion 201A of the upper surface 200AU of the conductive pad 200A. In some arrangements, the oxide layer 210AN may extend between the grains of the conductive pad 200A. A portion of the oxide layer 210AN may be formed along grain boundaries of the columnar grains of the conductive pad 200A. A portion of the oxide layer 210AN may be formed along boundaries of the nanotwinned crystals (or the nanotwins). With the nanotwined crystal structure of the conductive pad 200A having a relatively dense structure, the oxide layer 210AN may be formed along a portion of the grain boundaries proximal to the upper surface 200AU.

FIG. 3B is a cross-section of a portion of a package structure in accordance with some arrangements of the present disclosure. In some arrangements, FIG. 3B is a cross-section of a portion 3 of the package structure 1 in FIG. 1. The structure illustrated in FIG. 3B is similar to that in FIG. 3A, and the differences therebetween are described as follows.

In some arrangements, the package structure 1 may further include a protective layer 50A over the [111] crystallographic plane of the conductive pad 200A. In some arrangements, the protective layer 50A directly contacts the portion 201A of the upper surface 200AU. In some arrangements, the protective layer 50A directly contacts a portion (e.g., the stitch bond 320) of the conductive wire 300. In some arrangements, the conductive pad 200A is a NT-Cu pad, and the protective layer 50A is over the [111] crystallographic plane of the NT-Cu pad. In some arrangements, the conductive wire 300 (or the stitch bond 320) penetrates the protective layer 50A to directly contact the [111] crystallographic plane of the NT-Cu pad. In some arrangements, the protective layer 50A may be configured to prevent the conductive pad 200A from being oxidized or consumed by oxidation. In some arrangements, the protective layer 50A includes a metal material configured not to form an IMC with the conductive wire 300 and the conductive pad 200A. In some arrangements, the protective layer 50A includes a metal material configured not to form an IMC with the stitch bond 320 and the conductive pad 200A. In some arrangements, the conductive pad 200A is or includes a NT-Cu pad, and the protective layer 50A includes Au, Ni, Pd, other applicable metal materials, an alloy thereof, or a combination thereof.

In some arrangements, the package structure 1 may further include an alloy solid solution region R2 around a portion (e.g., the interface S2) of the upper surface 200AU of the conductive pad 200A. In some arrangements, a portion of the alloy solid solution region R2 is exposed to the protective layer 50A. In some arrangements, the alloy solid solution region R2 includes a region R21 including an alloy solid solution of the protective layer 50A and the conductive wire 300. In some arrangements, the alloy solid solution region R2 includes a region R22 including an alloy solid solution of the protective layer 50A and the conductive pad 200A.

In some arrangements, the package structure 1 may further include a transition layer 42A between the seed layer 40A and the conductive pad 200A. The transition layer 42A may include a polycrystal layer. In some arrangements, the transition layer 42A includes a plurality of crystal grains that have a size less than that of the crystal grains of the stitch bond 320. In some arrangements, the conductive pad 200A and the transition layer 42A include a same metal material. In some arrangements, the transition layer 42A includes Cu.

FIG. 3C is a cross-section of a portion of a package structure in accordance with some arrangements of the present disclosure. In some arrangements, FIG. 3C is a cross-section of a portion 3 of the package structure 1 in FIG. 1. The structure illustrated in FIG. 3C is similar to that in FIG. 3A, and the differences therebetween are described as follows.

In some arrangements, the substrate 10 includes a recess 10R, and the conductive pad 200A is disposed within the recess 10R. In some arrangements, the substrate 10 includes a base layer 10A and a dielectric layer 11 over the base layer 10A. In some arrangements, the lateral surface 202A of the conductive pad 200A directly contacts a sidewall of the recess 10R. The lateral surface 202A of the conductive pad 200A may be substantially flat. The lateral surface 202A of the conductive pad 200A may be defined by and conformal with the sidewall of the recess 10R. In some arrangements, the portion 201A of the upper surface 200AU is substantially aligned with an upper surface 111 of the dielectric layer 11.

FIG. 3D is a cross-section of a portion of a package structure in accordance with some arrangements of the present disclosure. In some arrangements, FIG. 3D is a cross-section of a portion 3 of the package structure 1 in FIG. 1. The structure illustrated in FIG. 3D is similar to that in FIG. 3A, and the differences therebetween are described as follows.

In some arrangements, the lateral surface 202A of the conductive pad 200A is substantially flat. The substantially flat morphology of the lateral surface 202A may be defined by a photoresist layer during the manufacturing process, and the photoresist has been removed after the conductive pad 200A has been formed in the manufacturing process.

In some arrangements, the conductive pad 200A and the conductive wire 300 include different materials. In some arrangements, the conductive wire 300 includes a metal material configured to form an alloy solid solution with the conductive pad 200A. In some arrangements, the conductive pad 200A includes a third metal material M3, and the conductive wire 300 includes the second metal material M2 configured to form an alloy solid solution with the third metal material M3. The third metal material M3 of the conductive pad 200A may be the same as or different from the first metal material M1 of the conductive pad 200. In some arrangements, the alloy solid solution region R2 includes an alloy solid solution of the conductive wire 300 and the conductive pad 200A. In some arrangements, the alloy solid solution region R2 includes a region R21 and a region R22 having different alloy compositions. In some arrangements, a concentration of the third metal material M3 in the region R21 is less than a concentration of the second metal material M2 in the region R21. In some arrangements, a concentration of the third metal material M3 in the region R22 is greater than a concentration of the second metal material M2 in the region R22. In some arrangements, the conductive pad 200A is or includes a NT-Cu pad, and the conductive wire 300 includes a gold (Au) wire, a Cu wire including less than about 1% of Au, a palladium (Pd) coated Cu wire, or a Cu wire including less than about 1% of Pd.

FIG. 3E is a cross-section of a portion of a package structure in accordance with some arrangements of the present disclosure. In some arrangements, FIG. 3E is a cross-section of a portion 3 of the package structure 1 in FIG. 1. The structure illustrated in FIG. 3E is similar to that in FIG. 3A, and the differences therebetween are described as follows.

In some arrangements, the oxide layer 210A includes sub-oxide layers 211A and 212A. The sub-oxide layers 211A and 211A may have different ratios of metal atoms to oxygen atoms. In some arrangements, a ratio of metal atoms to oxygen atoms of the sub-oxide layer 212A is greater than a ratio of metal atoms to oxygen atoms of the sub-oxide layer 211A. In some arrangements, the sub-oxide layer 211A includes CuO, and the sub-oxide layer 212A includes Cu₂O. In some arrangements, a thickness of the sub-oxide layer 211A is less than a thickness of the sub-oxide layer 212A.

In some arrangements, the oxide layer 220A includes sub-oxide layers 221A and 222A. The sub-oxide layers 221A and 222A may have different ratios of metal atoms to oxygen atoms. In some arrangements, a ratio of metal atoms to oxygen atoms of the sub-oxide layer 222A is greater than a ratio of metal atoms to oxygen atoms of the sub-oxide layer 221A. In some arrangements, the sub-oxide layer 221A includes CuO, and the sub-oxide layer 222A includes Cu₂O. In some arrangements, a thickness of the sub-oxide layer 221A is less than a thickness of oxide layer 210A. In some arrangements, a thickness of the sub-oxide layer 222A is less than a thickness of oxide layer 210A.

According to some arrangements of the present disclosure, the conductive wire and the conductive pad include the same material, such that electrolytic corrosion which could have been occurred to the conductive pad in a relatively humid environment due to potential differences among the different materials of the conductive pad and the conductive wire can be prevented. Moreover, the interface between the conductive wire and the conductive pad can be free of IMC, and thus formation of voids generated from volume changes resulted from phase changes during the formation of IMC can be prevented. Therefore, embrittlement of the conductive pad resulted from the IMC can be prevented, damage to the conductive pad due to the consumption of the material of the conductive pad in the formation of the IMC can be prevented as well, and thus the bonding strength between the conductive wire and the conductive pad can be increased.

In addition, according to some arrangements of the present disclosure, the conductive pad has a highly-oriented structure with a relatively dense crystallographic plane serving as the bonding surface (e.g., the [111] crystallographic plane of the NT-Cu pad). Due to the relatively dense crystal structure at the relatively dense crystallographic plane, native oxides are less prone to be formed on the relatively dense crystallographic plane. Therefore, native oxides (e.g., oxide layers 210 and 210A) formed on the bonding surface has a relatively thin thickness, which is advantageous to the subsequent bonding operation as well as improving the bonding strength between the conductive wire and the conductive pad. For example, it is relatively easy to remove the relatively thin native oxide layer to expose the bonding surface of the conductive pad for bonding to the conductive wire, and the as-formed bonding structure has an improved bonding strength due to the native oxides being substantially removed from the bonding interface. In addition, since the native oxides are formed of a relatively thin thickness, the native oxides (e.g., the oxide layers 210 and 210A) can serve to temporarily protect the bonding surface of the conductive pad.

Moreover, according to some arrangements of the present disclosure, the conductive pad has a highly-oriented structure with a crystallographic plane having a maximum ion diffusion rate (or a maximum metal diffusion rate) bonded to the conductive wire. Therefore, the relatively high diffusion rate is advantageous to the diffusion bonding between the conductive wire and the conductive pad, and thus the bonding strength is improved. Moreover, since the bonding surface of the conductive pad has a relatively high diffusion rate to facilitate an excellent diffusion bonding between the conductive pad and the conductive wire, planarization of the bonding surfaces that are usually performed on the bonding surfaces of hybrid bond structures are not required, and the bonding operation can be performed under a relatively low temperature (e.g., 100°C or lower). Accordingly, expensive and/or complicated equipment used for performing high-temperature copper to copper bonding operations are not required, which reduces the manufacturing costs and simplifies the manufacturing process, and devices/components in the package structure can be prevented from being damaged by a relatively high bonding temperature.

Furthermore, according to some arrangements of the present disclosure, the conductive pad is a NT-Cu pad with the [111] crystallographic plane as the bonding surface, and the conductive wire is a Cu wire. The [111] crystallographic plane of NT-Cu has a diffusivity of about 7.0×10⁻⁶ to about 1.2×10⁻⁵ under a temperature from about 150°C to about 250°C, while the [100] crystallographic plane and the [110] crystallographic plane of NT-Cu have a diffusivity of about 1.2×10⁻⁹ to about 6.6×10⁻¹² under a temperature from about 150°C to about 250°C. Therefore, the relatively high diffusion characteristics of the [111] crystallographic plane of NT-Cu provides an excellent diffusion bonding interface, such that the bonding interface (e.g., the interface S1/S2) can be up to about 85% of an area of the bonding surface (e.g., the surface 200U/200AU) of the conductive pad, which is advantageous to significantly increasing the bonding strength. In addition, Cu has a relatively low electron-migration resistance, a relatively high thermal dissipation, and a relatively high mechanical strength (e.g., tensile strength). Therefore, the bonding structure formed of the Cu wire and the NT-Cu pad has excellent electrical performance and heat dissipation ability, and cratering and splash that usually occur when a conductive wire is bonded to a relatively soft aluminum pad can be effectively prevented. Accordingly, the package structure including the aforesaid structure can have a relatively reliability and stability.

FIG. 4A, FIG. 4B, FIG. 4C, FIG. 4D, and FIG. 4E illustrate various stages of an example of a method for manufacturing a package structure 1 in accordance with some arrangements of the present disclosure.

Referring to FIG. 4A, a conductive pad 200 may be formed over a substrate 100, and a wire bonding apparatus 900 may be used to dispose a conductive wire 300 directly above the conductive pad 200. A seed layer 40 may be formed on the substrate 100, and the conductive pad 200 may be plated on the seed layer 40. In some arrangements, the conductive pad 200 is or includes a nanotwinned copper (NT-Cu) pad. In some arrangements, an oxide layer 210 may be further disposed or formed over a [111] crystallographic plane of the NT-Cu pad. The oxide layer 210 may include sub-oxide layers 211 and 212 similar to those illustrated in FIG. 2E. In some arrangements, an oxide layer 220 may be further disposed or formed over a non-[111] crystallographic plane of the NT-Cu pad. The oxide layers 210 and 220 may be native oxide layers grown from the conductive pad 200. In some other arrangements, an organic protective layer (not shown in FIG. 4A) may be formed on over the [111] crystallographic plane of the NT-Cu pad, such that the oxide layer 210 may not be formed at the present stage. The organic protective layer may be or include organic solderability preservative (OSP). In some arrangements, the conductive wire 300 includes a wire portion 330 and a ball bond 310 connected to the wire portion 330, and the ball bond 310 is directly above the conductive pad 200.

Referring to FIG. 4B, the conductive wire 300 may be moved toward and pressed against the conductive pad 200, and an energy may be applied on the conductive pad 200 to allow the conductive wire 300 to penetrate the oxide layer 210 and directly contact the [111] crystallographic plane of the conductive pad 200. In some arrangements, the ball bond 310 may be moved toward and pressed against the conductive pad 200 to bond to the conductive pad 200 when applying the energy on the conductive pad 200. In some arrangements, the energy may be applied to break down the oxide layer 210. In some arrangements, the energy may be applied to break down the sub-oxide layers 211 and 212 (now shown in FIG. 4B). In some arrangements, applying the energy on the conductive pad 200 includes applying heat, pressure, ultrasonic energy, spark discharge, or a combination thereof. In some arrangements, the energy may be applied to allow the ball bond 310 to connect to the conductive pad 200 through diffusion bonding. In some arrangements, referring to FIGS. 4A and 4B, a surface roughness of an upper surface 200U of the conductive pad 200 may be increased after the ball bond 310 is pressed against and contacting the upper surface 200U of the conductive pad 200. In some other arrangements, the organic protective layer may be removed before the conductive wire 300 is bonded to the conductive pad 200, and the oxide layer 210 may be formed after the organic protective layer is removed and the conductive wire 300 is bonded to the conductive pad 200.

In some arrangements, an oxide layer 311 may be further disposed or formed on the ball bond 310. The oxide layer 311 may be or include a native oxide layer of the ball bond 310. The oxide layer 311 may be formed at least during the process of bonding the ball bond 310 to the conductive pad In some arrangements, the conductive pad 200 is a NT-Cu pad, the oxide layer 210 includes a native oxide on the [111] crystallographic plane of the NT-Cu pad, and the oxide layer 220 includes a native oxide on the non-[111] crystallographic plane of the NT-Cu pad. In some arrangements, the oxide layer 210 includes a native oxide layer grown from the [111] crystallographic plane of the NT-Cu pad. In some arrangements, the oxide layer 220 includes a native oxide layer grown from the non-[111] crystallographic plane of the NT-Cu pad. In some arrangements, applying the energy on the NT-Cu pad includes removing at least a portion of the oxide layer 210 to expose the [111] crystallographic plane of the NT-Cu pad. In some arrangements, the ball bond 310 is bonded to the exposed [111] crystallographic plane of the NT-Cu pad.

According to some arrangements of the present disclosure, since the oxide layer 210 is a native oxide layer grown from the [111] crystallographic plane of the NT-Cu pad, the oxide layer 210 can have a relatively small thickness. Therefore, the energy used to break the oxide layer 210 can be relatively low, which is advantageous to lowering the bonding temperature and hence reducing the thermal stress impact which could have been generated from a heterogeneous bonding interface.

Referring to FIG. 4C, a conductive pad 200A may be formed over a substrate 10, and the wire bonding apparatus 900 (or a capillary of the wire bonding apparatus 900) may be moved toward the conductive pad 200A to allow a bent portion 320A of the conductive wire 300 be located directly above the conductive pad 200A. A seed layer 40A may be formed on the substrate 10, and the conductive pad 200A may be plated on the seed layer 40A. In some arrangements, the conductive pad 200A is or includes a nanotwinned copper (NT-Cu) pad. In some arrangements, an oxide layer 210A may be further disposed or formed over a [111] crystallographic plane of the NT-Cu pad. In some arrangements, an oxide layer 220A may be further disposed or formed over a non-[111] crystallographic plane of the NT-Cu pad. The oxide layers 210A and 220A may be native oxide layers grown from the conductive pad 200A. The wire portion 330 connected to the bent portion 320A may form a wire loop.

Referring to FIG. 4D, the conductive wire 300 may be moved toward and pressed against the conductive pad 200A, and an energy may be applied on the conductive pad 200A to allow the conductive wire 300 to penetrate the oxide layer 210A and directly contact the [111] crystallographic plane of the conductive pad 200A. In some arrangements, the bent portion 320A of the conductive wire 300 may be moved toward and pressed against the conductive pad 200A to bond to the conductive pad 200A when applying the energy on the conductive pad 200A. In some arrangements, similar to the operations illustrated in FIG. 4B, an energy may be applied on the conductive pad 200A to allow the bent portion 320A of the conductive wire 300 to penetrate the oxide layer 210A and directly contact the [111] crystallographic plane of the conductive pad 200A. In some arrangements, the energy may be applied to break down the oxide layer 210A. In some arrangements, applying the energy on the conductive pad 200A includes applying heat, pressure, ultrasonic energy, spark discharge, or a combination thereof. In some arrangements, the energy may be applied to allow the bent portion 320A to connect to the conductive pad 200A through diffusion bonding.

Referring to FIG. 4E, the wire bonding apparatus 900 may be pulled upwardly until the bent portion 320A is ruptured and separated from the remained wire portion in the wire bonding apparatus 900 to form a stitch bond 320 on the conductive pad 200A. An oxide layer 321 may be further formed on the stitch bond 320. The oxide layer 321 may be or include a native oxide layer of the stitch bond 320. As such, the package structure 1 illustrated in FIG. 1 is formed. The package structure formed by operations illustrated in FIGS. 4A-4E may include one or more structures as illustrated in FIGS. 2A, 2C-2E, 3A, and 3C-3E.

FIG. 5A, FIG. 5B, FIG. 5C, FIG. 5D, FIG. 5E, and FIG. 5F illustrate various stages of an example of a method for manufacturing a package structure in accordance with some arrangements of the present disclosure.

Referring to FIG. 5A, a conductive pad 200 may be formed over a substrate 100, and a wire bonding apparatus 900 may be used to dispose a conductive wire 300 directly above the conductive pad 200. A seed layer 40 may be formed on the substrate 100, and the conductive pad 200 may be plated on the seed layer 40. A transition layer 42 may be formed between the conductive pad 200 and the seed layer 40. In some arrangements, the conductive pad 200 is or includes a nanotwinned copper (NT-Cu) pad. In some arrangements, a protective layer 50 may be further disposed or formed over a [111] crystallographic plane of the NT-Cu pad. The protective layer 50 may include a metal material. In some arrangements, an oxide layer 220 may be further disposed or formed over a non-[111] crystallographic plane of the NT-Cu pad. The oxide layer 220 may be a native oxide layer grown from the conductive pad 200. In some arrangements, the conductive wire 300 includes a wire portion 330 and a ball bond 310 connected to the wire portion 330, and the ball bond 310 is directly above the conductive pad 200.

Referring to FIG. 5B, the conductive wire 300 may be moved toward and pressed against the conductive pad 200. In some arrangements, the ball bond 310 may be moved toward and pressed against the conductive pad 200. In some arrangements, referring to FIGS. 5A and 5B, a surface roughness of an upper surface 200U of the conductive pad 200 may be increased after the ball bond 310 is pressed against and contacting the upper surface 200U of the conductive pad 200.

Referring to FIG. 5C, an energy may be applied on the conductive pad 200 to allow the conductive wire 300 to penetrate the protective layer 50 and directly contact the [111] crystallographic plane of the conductive pad 200. In some arrangements, the ball bond 310 may be moved toward and pressed against the conductive pad 200 to bond to the conductive pad 200 when applying the energy on the conductive pad 200. In some arrangements, the energy may be applied to form an alloy solid solution region R1 around an interface S1 between the conductive pad 200 and the conductive wire 300. In some arrangements, applying the energy on the conductive pad 200 includes applying heat, pressure, ultrasonic energy, spark discharge, or a combination thereof. In some arrangements, the energy may be applied to allow the ball bond 310 to connect to the conductive pad 200 through diffusion bonding. In some arrangements, the alloy solid solution region R1 includes an alloy solid solution of the metal material of the protective layer 50, the conductive pad 200, and the conductive wire 300. In some arrangements, the conductive pad 200 is a NT-Cu pad, the alloy solid solution region R1 includes an alloy solid solution of the metal material of the protective layer 50, the NT-Cu pad, and the ball bond 310.

Referring to FIG. 5D, a conductive pad 200A may be formed over a substrate 10, and the wire bonding apparatus 900 (or a capillary of the wire bonding apparatus 900) may be moved toward the conductive pad 200A to allow a bent portion 320A of the conductive wire 300 be located directly above the conductive pad 200A. A seed layer 40A may be formed on the substrate 10, and the conductive pad 200A may be plated on the seed layer 40A. A transition layer 42A may be formed between the conductive pad 200A and the seed layer 40A. In some arrangements, the conductive pad 200A is or includes a nanotwinned copper (NT-Cu) pad. In some arrangements, a protective layer 50A may be further disposed or formed over a [111] crystallographic plane of the NT-Cu pad. The protective layer 50A may include a metal material. In some arrangements, an oxide layer 220A may be further disposed or formed over a non-[111] crystallographic plane of the NT-Cu pad. The oxide layer 220A may be a native oxide layer grown from the conductive pad 200A. The wire portion 330 connected to the bent portion 320A may form a wire loop.

Referring to FIG. 5E, the conductive wire 300 may be moved toward and pressed against the conductive pad 200A, and an energy may be applied on the conductive pad 200A to allow the conductive wire 300 to penetrate the protective layer 50A and directly contact the [111] crystallographic plane of the conductive pad 200A. In some arrangements, the bent portion 320A of the conductive wire 300 may be moved toward and pressed against the conductive pad 200A to bond to the conductive pad 200A when applying the energy on the conductive pad 200A. In some arrangements, similar to the operations illustrated in FIG. 5B, an energy may be applied on the conductive pad 200A to allow the bent portion 320A of the conductive wire 300 to penetrate the protective layer 50 and directly contact the [111] crystallographic plane of the conductive pad 200A. In some arrangements, the energy may be applied to form an alloy solid solution region R2 around an interface S2 between the conductive pad 200A and the conductive wire 300. In some arrangements, applying the energy on the conductive pad 200A includes applying heat, pressure, ultrasonic energy, spark discharge, or a combination thereof. In some arrangements, the energy may be applied to allow the bent portion 320A to connect to the conductive pad 200A through diffusion bonding. In some arrangements, the alloy solid solution region R2 includes an alloy solid solution of the metal material of the protective layer 50A, the conductive pad 200A, and the conductive wire 300. In some arrangements, the conductive pad 200A is a NT-Cu pad, the alloy solid solution region R2 includes an alloy solid solution of the metal material of the protective layer 50A, the NT-Cu pad, and the bent portion 320A.

Referring to FIG. 5F, the wire bonding apparatus 900 may be pulled upwardly until the bent portion 320A is ruptured and separated from the remained wire portion in the wire bonding apparatus 900 to form a stitch bond 320 on the conductive pad 200A. An oxide layer 321 may be further formed on the stitch bond 320. The oxide layer 321 may be or include a native oxide layer of the stitch bond 320. As such, the package structure 1 illustrated in FIG. 1 is formed. The package structure formed by operations illustrated in FIGS. 5A-5F may include one or more structures as illustrated in FIGS.2B and 3B.

FIG. 6 is a schematic view of a portion of a package structure after a shear test is performed in accordance with some arrangements of the present disclosure.

In some arrangements, a shear test may be performed on a structure as illustrated in any one of FIGS. 2A-2E. FIG. 6 shows that the breakage occurs between crystal grains (e.g., at a top of the crystal grain 3101) of the ball bond 310 rather than at the interface S1 between the ball bond 310 and the conductive pad 200. It indicates that the shear strength in the ball bond 310 is less than a shear strength at the interface S1 between the ball bond 310 and the conductive pad 200.

As used herein, the terms "approximately," "substantially," "substantial" and "about" are used to describe and account for small variations. When used in conjunction with an event or circumstance, the terms can refer to instances in which the event or circumstance occurs precisely as well as instances in which the event or circumstance occurs to a close approximation. For example, when used in conjunction with a numerical value, the terms can refer to a range of variation less than or equal to ±10% of said numerical value, such as less than or equal to ±5%, less than or equal to ±4%, less than or equal to ±3%, less than or equal to ±2%, less than or equal to ±1%, less than or equal to ±0.5%, less than or equal to ±0.1%, or less than or equal to ±0.05%. For example, two numerical values can be deemed to be "substantially" or "about" the same if a difference between the values is less than or equal to ±10% of an average of the values, such as less than or equal to ±5%, less than or equal to ±4%, less than or equal to ±3%, less than or equal to ±2%, less than or equal to ±1%, less than or equal to ±0.5%, less than or equal to ±0.1%, or less than or equal to ±0.05%. For example, "substantially" parallel can refer to a range of angular variation relative to 0° that is less than or equal to ±10°, such as less than or equal to ±5°, less than or equal to ±4°, less than or equal to ±3°, less than or equal to ±2°, less than or equal to ±1°, less than or equal to ±0.5°, less than or equal to ±0.1°, or less than or equal to ±0.05°. For example, "substantially" perpendicular can refer to a range of angular variation relative to 90° that is less than or equal to ±10°, such as less than or equal to ±5°, less than or equal to ±4°, less than or equal to ±3°, less than or equal to ±2°, less than or equal to ±1°, less than or equal to ±0.5°, less than or equal to ±0.1°, or less than or equal to ±0.05°.

Two surfaces can be deemed to be coplanar or substantially coplanar if a displacement between the two surfaces is no greater than 5µm, no greater than 2µm, no greater than 1µm, or no greater than 0.5µm.

As used herein, the terms "conductive," "electrically conductive" and "electrical conductivity" refer to an ability to transport an electric current. Electrically conductive materials typically indicate those materials that exhibit little or no opposition to the flow of an electric current. One measure of electrical conductivity is Siemens per meter (S/m). Typically, an electrically conductive material is one having a conductivity greater than approximately 104 S/m, such as at least 105 S/m or at least 106 S/m. The electrical conductivity of a material can sometimes vary with temperature. Unless otherwise specified, the electrical conductivity of a material is measured at room temperature.

As used herein, the singular terms "a," "an," and "the" may include plural referents unless the context clearly dictates otherwise. In the description of some arrangements, a component provided "on" or "over" another component can encompass cases where the former component is directly on (e.g., in physical contact with) the latter component, as well as cases where one or more intervening components are located between the former component and the latter component.

While the present disclosure has been described and illustrated with reference to specific arrangements thereof, these descriptions and illustrations do not limit the present disclosure. It can be clearly understood by those skilled in the art that various changes may be made, and equivalent components may be substituted within the arrangements without departing from the true spirit and scope of the present disclosure as defined by the appended claims. The illustrations may not necessarily be drawn to scale. There may be distinctions between the artistic renditions in the present disclosure and the actual apparatus, due to variables in manufacturing processes and the like. There may be other arrangements of the present disclosure which are not specifically illustrated. The specification and drawings are to be regarded as illustrative rather than restrictive. Modifications may be made to adapt a particular situation, material, composition of matter, method, or process to the objective, spirit and scope of the present disclosure. All such modifications are intended to be within the scope of the claims appended hereto. While the methods disclosed herein have been described with reference to particular operations performed in a particular order, it can be understood that these operations may be combined, sub-divided, or re-ordered to form an equivalent method without departing from the teachings of the present disclosure. Therefore, unless specifically indicated herein, the order and grouping of the operations are not limitations of the present disclosure.

## Claims

1. A package structure, comprising:
a substrate (10/100);
a first conductive pad (200) disposed over the substrate (10/100) and having an anisotropic crystal structure;
a first oxide layer (210+220) over the first conductive pad (200); and
a conductive wire (300) comprising an end portion (310) penetrating the first oxide layer and contacting the anisotropic crystal structure.

2. The package structure as claimed in claim 1, wherein the end portion (310) comprises a first grain (3101), the first conductive pad (200) comprises a second grain (2002) and a third grain (2003), and the first grain is at least partially between the second grain and the third grain.

3. The package structure as claimed in claim 2, wherein the first grain (3101) contacts a crystallographic plane of the second grain (2002) and a crystallographic plane of the third grain (2003).

4. The package structure as claimed in claim 3, wherein the end portion (310) further comprises a fourth grain (3104) adjacent to the first grain, and a gap between the first grain (3101) and the fourth grain (3104) is greater than a gap between the second grain (2002) and the third grain (2003).

5. The package structure as claimed in claim 1, wherein the first conductive pad (200) comprises a first grain (2001) including a first upstanding portion (2001C1) proximal to the substrate (10/100) and a first bending portion (2001C2) proximal to the end portion (310), and the first bending portion (2001C2) is more inclined than the first upstanding portion (2001C1) with respect to the substrate in a cross-sectional view.

6. The package structure as claimed in claim 5, wherein the first conductive pad (200) further comprises a second grain (2005) adjacent to the first grain, the second grain comprises a second upstanding portion and a second bending portion (2005C) over the second upstanding portion, and the second bending portion (2005C) is less inclined than the first bending portion (2001C2) with respect to the substrate in the cross-sectional view.

7. The package structure as claimed in claim 6, wherein the second grain (2005) is not in contact with the end portion (310).

8. The package structure as claimed in claim 1, further comprising a second oxide layer (311) covering the conductive wire (300), wherein a thickness (T2) of the second oxide layer (311) is greater than a thickness (T1) of the first oxide layer (210).

9. The package structure as claimed in claim 1, wherein the anisotropic crystal structure has a [111] crystallographic plane, the first oxide layer (210+220) comprises a first portion (210) over the [111] crystallographic plane and a second portion (220) on a lateral side of the [111] crystallographic plane, and a thickness (T1) of the first portion (210) is less than a thickness (T3) of the second portion (220).

10. The package structure as claimed in claim 9, further comprising a third oxide layer (210N) embedded in the anisotropic crystal structure, wherein a thickness (T4) of the third oxide layer (210N) is less than a thickness (T1) of the first oxide layer (210).

11. The package structure as claimed in claim 1, further comprises a second conductive pad (200A), wherein the first conductive pad (200) comprises a plurality of first multi-layers stacked along a first direction (A1), the second conductive pad (200A) comprises a plurality of second multi-layers stacked along a second direction (A2), and the first direction is more inclined than the second direction with respect to the substrate.

12. The package structure as claimed in claim 1, further comprises a second conductive pad (200A), wherein the first conductive pad (200) comprises a plurality of first nanotwinned layers stacked along a first [111] crystal axis (A1), the second conductive pad (200A) comprises a plurality of second nanotwinned layers stacked along a second [111] crystal axis (A2), and the first [111] crystal axis (A1) and the second [111] crystal axis (A2) extend in different directions.

13. A method of manufacturing a package structure, comprising:
forming a pad (200/200A) over a substrate (10), the pad having an anisotropic crystal structure;
forming an oxide layer (210) over the pad; and
applying an energy on the pad (200/200A) to allow a conductive wire (300) to penetrate the oxide layer (210) and directly contact the anisotropic crystal structure.

14. The method as claimed in claim 13, wherein applying the energy on the pad further comprises forming an alloy solid solution region (R1/R2) around an interface (S1/S2) between the pad (200/200A) and the conductive wire (300).

15. The method as claimed in claim 13, wherein applying the energy on the pad (200/200A) comprises applying heat, pressure, ultrasonic energy, spark discharge, or a combination thereof.
